(19) Europäisches Patentamt
European Patent Office
Office européen des brevets

(11) **EP 4 083 156 A1**

(12) **EUROPEAN PATENT APPLICATION**
published in accordance with Art. 153(4) EPC

(43) Date of publication:
**02.11.2022 Bulletin 2022/44**

(21) Application number: **20907741.1**

(22) Date of filing: **30.11.2020**

(51) International Patent Classification (IPC):
*C09J 11/06* (2006.01)    *C09J 201/00* (2006.01)
*H01L 21/301* (2006.01)    *C09J 7/20* (2018.01)
*C09J 7/24* (2018.01)    *C09J 7/38* (2018.01)

(52) Cooperative Patent Classification (CPC):
**C09J 7/20; C09J 7/24; C09J 7/38; C09J 11/06;
C09J 201/00; H01L 21/30**

(86) International application number:
**PCT/JP2020/044515**

(87) International publication number:
**WO 2021/131518 (01.07.2021 Gazette 2021/26)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **27.12.2019  JP 2019237687
01.07.2020  JP 2020114066**

(71) Applicant: **Nitto Denko Corporation**
**Ibaraki-shi, Osaka 567-8680 (JP)**

(72) Inventors:
• **UENO, Shusaku**
**Ibaraki-shi, Osaka 567-8680 (JP)**
• **HIRAYAMA, Takamasa**
**Ibaraki-shi, Osaka 567-8680 (JP)**

(74) Representative: **Müller-Boré & Partner
Patentanwälte PartG mbB
Friedenheimer Brücke 21
80639 München (DE)**

(54) **ADHESIVE SHEET**

(57)    Provided is a pressure-sensitive adhesive sheet capable of allowing a small electronic part (e.g., a chip having a size of 50 $\mu$m/$\square$ or less) to be temporarily fixed in a satisfactory manner and satisfactorily peeled. The pressure-sensitive adhesive sheet of the present invention includes a gas-generating layer configured to generate a gas by being irradiated with laser light, wherein a modulus of elasticity $Er(gas)$ [unit: MPa] of the gas-generating layer measured by a nanoindentation method and a thickness $h(gas)$ [unit: $\mu$m] thereof satisfy the following expression (1):
$Log(Er(gas) \times 10^6) \geq 8.01 \times h(gas)^{-0.116} \cdots (1)$. In one embodiment, the pressure-sensitive adhesive sheet has a transmittance of from 0% to 35% for light having a wavelength of 360 nm. In one embodiment, the pressure-sensitive adhesive sheet has a transmittance of from 10% to 100% for light having a wavelength of 380 nm.

100

Fig.1(a)

10
30

**(Cont. next page)**

EP 4 083 156 A1

Fig.1(b)

200

20
10
30

**Description**

Technical Field

The present invention relates to a pressure-sensitive adhesive sheet.

Background Art

Hitherto, in processing, transportation, and the like of an electronic part, an operation involving temporarily fixing an electronic part onto a pressure-sensitive adhesive sheet during processing, transportation, and the like, and peeling the electronic part from the pressure-sensitive adhesive sheet after processing and transportation has been performed in some cases. As the pressure-sensitive adhesive sheet to be used in such operation, there is sometimes used a pressure-sensitive adhesive sheet having a predetermined pressure-sensitive adhesive strength during processing and transportation (at the time of electronic part reception), and being capable of having its pressure-sensitive adhesive strength decreased after processing and transportation (at the time of electronic part delivery). As one such pressure-sensitive adhesive sheet, there is a proposal of a pressure-sensitive adhesive sheet having a configuration in which its pressure-sensitive adhesive layer contains thermally expandable microspheres (for example, Patent Literature 1). The pressure-sensitive adhesive sheet containing the thermally expandable microspheres has the following feature: while the sheet has a predetermined pressure-sensitive adhesive strength, the pressure-sensitive adhesive strength is decreased or eliminated by expanding the thermally expandable microspheres through heating to form unevenness on its pressure-sensitive adhesive surface, resulting in a reduced contact area. Such pressure-sensitive adhesive sheet has an advantage in that an adherend can be easily peeled therefrom without an external stress.

However, in recent years, along with tendencies of various devices to be lightweighted and mounted in increasing numbers, downsizing of an electronic part has been advanced, resulting in a need to temporarily fix an electronic part downsized to a size comparable to those of the thermally expandable microspheres. When the electronic part whose downsizing has advanced is treated while being temporarily fixed, and is then peeled, the unevenness needs to be formed on the pressure-sensitive adhesive surface in a range narrower than the bonding area of the adherend at the time of the peeling, and position-selective expression of peelability is required. However, in the related-art pressure-sensitive adhesive sheet containing the thermally expandable microspheres, such influences as described below become larger as a result of their particle diameter variation. At a site where the thermally expandable microspheres having large particle diameters are present, a plurality of electronic parts arranged adjacent to the electronic part to be peeled are erroneously peeled, and at a site where no thermally expandable microspheres are present, the unevenness cannot be formed on the pressure-sensitive adhesive surface having bonded thereto the electronic part to be peeled. Accordingly, satisfactory peeling cannot be performed at the sites in some cases.

Citation List

Patent Literature

[PTL 1] JP 2001-131507 A

Summary of Invention

Technical Problem

The present invention has been made to solve the problem of the related art described above, and an object of the present invention is to provide a pressure-sensitive adhesive sheet capable of allowing a small electronic part (e.g., a chip having a size of 50 $\mu$m/□ or less) to be temporarily fixed in a satisfactory manner and satisfactorily peeled.

Solution to Problem

According to one aspect of the present invention, there is provided a pressure-sensitive adhesive sheet, including a gas-generating layer configured to generate a gas by being irradiated with laser light, wherein a modulus of elasticity Er(gas) [unit: MPa] of the gas-generating layer measured by a nanoindentation method and a thickness h(gas) [unit: $\mu$m] thereof satisfy the following expression (1).

$$\mathrm{Log}(\mathrm{Er}(\mathrm{gas}) \times 10^6) \geq 8.01 \times \mathrm{h}(\mathrm{gas})^{-0.116} \cdots (1)$$

In one embodiment, the pressure-sensitive adhesive sheet has a transmittance of from 0% to 40% for light having a wavelength of 360 nm.

In one embodiment, the pressure-sensitive adhesive sheet has a transmittance of from 10% to 100% for light having a wavelength of 380 nm.

In one embodiment, the gas-generating layer contains a UV absorber, and the UV absorber has a maximum absorption wavelength of 360 nm or less.

In one embodiment, the gas-generating layer is a cured product of an active energy ray-curable composition.

In one embodiment, the gas-generating layer contains an acrylic polymer.

In one embodiment, the pressure-sensitive adhesive sheet further includes a gas barrier layer on at least one side of the gas-generating layer, wherein the gas barrier layer has a modulus of elasticity of from 0.1 MPa to 100 MPa, which is measured by the nanoindentation method.

In one embodiment, the gas barrier layer has a thickness of from 0.1 $\mu$m to 50 $\mu$m.

In one embodiment, the gas barrier layer shows a pressure-sensitive adhesive property.

In one embodiment, the pressure-sensitive adhesive sheet has a transmittance of from 70% to 100% for light having a wavelength of 500 nm.

In one embodiment, the pressure-sensitive adhesive sheet has a haze value of 50% or less.

In one embodiment, a surface of the pressure-sensitive adhesive sheet is deformed by being irradiated with laser light.

In one embodiment, the surface of the pressure-sensitive adhesive sheet is deformed into a protrusion shape by being irradiated with the laser light.

In one embodiment, a horizontal displacement of the surface of the pressure-sensitive adhesive sheet by the irradiation of the pressure-sensitive adhesive sheet with the laser light is 50 $\mu$m or less.

According to another aspect of the present invention, there is provided a method of treating an electronic part. The method of treating an electronic part includes: bonding an electronic part onto the pressure-sensitive adhesive sheet; and peeling the electronic part from the pressure-sensitive adhesive sheet by irradiating the pressure-sensitive adhesive sheet with laser light.

In one embodiment, the peeling the electronic part is performed in a position-selective manner.

In one embodiment, the method of treating an electronic part further includes subjecting the electronic part to a predetermined treatment after the bonding the electronic part onto the pressure-sensitive adhesive sheet and before the peeling the electronic part from the pressure-sensitive adhesive sheet.

In one embodiment, the treatment is grinding processing, dicing processing, die bonding, wire bonding, etching, vapor deposition, molding, circuit formation, inspection, a product check, cleaning, transfer, arrangement, repair, or protection of a device surface.

In one embodiment, the method of treating an electronic part further includes placing the electronic part on another sheet after the peeling the electronic part from the pressure-sensitive adhesive sheet.

Advantageous Effects of Invention

According to the present invention, it is possible to provide the pressure-sensitive adhesive sheet capable of allowing a small electronic part (e.g., a chip having a size of 50 $\mu$m/$\square$ or less) to be temporarily fixed in a satisfactory manner, the pressure-sensitive adhesive sheet being capable of allowing the small electronic part to be satisfactorily peeled by virtue of including the gas-generating layer capable of generating a gas through laser light irradiation.

Brief Description of Drawings

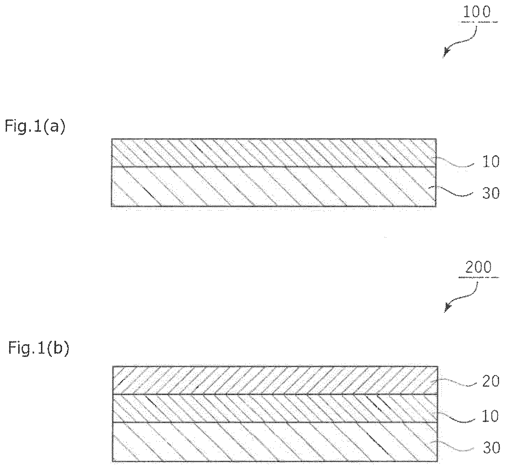

FIG. **1(a)** is a schematic sectional view of a pressure-sensitive adhesive sheet according to one embodiment of the present invention, and FIG. **1(b)** is a schematic sectional view of a pressure-sensitive adhesive sheet according to another embodiment of the present invention.

Description of Embodiments

A. Outline of Pressure-sensitive Adhesive Sheet

FIG. **1(a)** is a schematic sectional view of a pressure-sensitive adhesive sheet according to one embodiment of the present invention. A pressure-sensitive adhesive sheet **100** according to this embodiment includes a gas-generating layer **10**. FIG. **1(b)** is a schematic sectional view of a pressure-sensitive adhesive sheet according to another embodiment of the present invention. A pressure-sensitive adhesive sheet **200** according to this embodiment further includes a gas barrier layer **20** arranged on at least one surface of the gas-generating layer **10**. As illustrated in FIG. **1(a),** the pressure-sensitive adhesive sheet **100** may further include a base material **30** on one surface of the gas-generating layer 10. In addition, when the gas-generating layer **10** and the gas barrier layer **20** are arranged, as illustrated in FIG. **1(b),** the pressure-sensitive adhesive sheet **200** may further include the base material **30** on the side of the gas-generating layer **10** opposite to the gas barrier layer **20**. In addition, the pressure-sensitive adhesive sheet may further include any appropriate other layer as long as the effects of the present invention are obtained. In one embodiment, the pressure-sensitive adhesive sheet may further include a pressure-sensitive adhesive layer arranged on the side of the gas-generating layer opposite to the gas barrier layer. The form of the pressure-sensitive adhesive layer is not limited, and the layer may be a curable pressure-sensitive adhesive layer, or may be a pressure-sensitive adhesive layer having pressure sensitivity. In the pressure-sensitive adhesive sheet of the present invention, a release liner may be arranged outside the gas-generating layer or the gas barrier layer for the purpose of protecting the pressure-sensitive adhesive surface of the sheet until the sheet is subjected to use, though the liner is not shown.

The gas-generating layer **10** generates a gas through laser light irradiation. More specifically, the gas-generating layer **10** is a layer that generates a gas through the gasification of a component thereof by laser light irradiation. UV laser light is typically used as the laser light. The surface of the pressure-sensitive adhesive sheet may be deformed by irradiating the pressure-sensitive adhesive sheet (substantially the gas-generating layer) with laser light. UV laser light is typically used as the laser light.

In one embodiment, the gas-generating layer and the gas barrier layer each have a pressure-sensitive adhesive property. The phrase "have a pressure-sensitive adhesive property" as used herein means that the pressure-sensitive adhesive strength of such layer at 23°C when bonded to a stainless-steel plate is 0.1 N/20 mm or more.

In the pressure-sensitive adhesive sheet including the gas barrier layer **20,** the surface of the gas barrier layer **20** may be deformed by irradiating the pressure-sensitive adhesive sheet (substantially the gas-generating layer) with laser light. In one embodiment, the deformation results from the gas generated from the gas-generating layer **10,** and may occur on the side of the gas barrier layer **20** opposite to the gas-generating layer **10.** In one embodiment, the gas barrier layer has a pressure-sensitive adhesive property.

The pressure-sensitive adhesive sheet of the present invention may be used by bonding a workpiece such as an electronic part to the surface of the pressure-sensitive adhesive sheet (the surface of the gas-generating layer in the form illustrated in FIG. **1(a)** or the gas barrier layer in the form illustrated in FIG. **1(b)**). The pressure-sensitive adhesive sheet of the present invention includes the gas-generating layer, and partly generates a gas in a fine range through laser light irradiation. The gas generation causes the surface of the pressure-sensitive adhesive sheet to deform, and as a result, peelability is expressed in the portion irradiated with laser light. According to the present invention, the deformation can be caused in a fine range as described above, and hence, even in the processing of a small electronic part that is extremely fine, the small electronic part can be satisfactorily peeled. In addition, even when a small electronic part that needs to be peeled and a small electronic part that does not need to be peeled are temporarily fixed so as to be adjacent to each other, it is possible to perform peeling at the site to be peeled and prevent peeling at the site not to be peeled. That is, only the small electronic part that needs to be peeled can be peeled, and unnecessary separation of a small electronic part can be prevented. The pressure-sensitive adhesive sheet of the present invention is excellent in directivity at the time of peeling and peelable only at a desired site, and hence has an advantage in that breakage is prevented and an adhesive residue is reduced as well. The directivity at the time of peeling is an indicator showing positional accuracy when an adherend such as a small electronic part is to be peeled from the pressure-sensitive adhesive sheet and ejected toward a place at a certain distance. When the directivity is excellent, the adherend is prevented from flying in an unexpected direction at the time of peeling.

The deformation of the pressure-sensitive adhesive sheet means displacements occurring in the normal direction (thickness direction) and horizontal direction (direction orthogonal to the thickness direction) of the surface of the pressure-sensitive adhesive sheet (the surface of the gas-generating layer in the form illustrated in FIG. **1(a)** or the gas barrier layer in the form illustrated in FIG. **1(b)**). The deformation of the pressure-sensitive adhesive sheet is caused by, for example, performing a pulse scan with UV laser light having a wavelength of 355 nm and a beam diameter of about 20 $\mu m\varphi$ at an output of 0.80 mW and a frequency of 40 kHz to generate a gas from the gas-generating layer. A shape after the deformation is observed, for example, from measurement with a confocal laser microscope, a noncontact interference microscope (WYKO), or the like on any appropriate one spot subjected to the pulse scan after 24 hours from the laser light irradiation. The shape may be foaming (protrusion shape), a through-hole (uneven shape), or a recess (depression shape), and any such deformation may generate peelability. In order to efficiently peel an electronic part in the normal direction, a change in displacement in the normal direction between before and after the laser light irradiation is preferably large, and such a change as to form a foaming shape is particularly suitable. With regard to the foaming (protrusion shape), its highest point and full width at half maximum with reference to an unirradiated portion of the surface of the pressure-sensitive adhesive sheet are defined as a vertical displacement Y and a horizontal displacement X (diameter), respectively. With regard to the through-hole (unevenness) and the recess (depression) each forming a hole after the laser light irradiation, the difference between the highest point and the lowest point is defined as the vertical displacement Y, and the diameter of the hole is defined as the horizontal displacement X. The horizontal displacement of the surface of the pressure-sensitive adhesive sheet by the irradiation of the pressure-sensitive adhesive sheet with laser light is preferably 50 μm or less, more preferably 40 μm or less, still more preferably 30 μm or less. When the horizontal displacement falls within such ranges, a small adherend can be preferably peeled only at a desired site. In addition, even when adherends are arranged at a small interval, a similar effect can be expected. The lower limit of the horizontal displacement is, for example, 3 μm (preferably 4 μm).

The transmittance of the pressure-sensitive adhesive sheet of the present invention for light having a wavelength of 360 nm is preferably from 0% to 40%, more preferably from 0% to 35%, still more preferably from 0.01% to 30%, particularly preferably from 0.02% to 25%. In addition, the transmittance of the pressure-sensitive adhesive sheet for light having a wavelength of 380 nm is preferably from 10% to 100%, more preferably from 12% to 95%, still more preferably from 15% to 90%, particularly preferably from 20% to 85%. The light transmittance of the pressure-sensitive adhesive sheet is a light transmittance in the thickness direction of the pressure-sensitive adhesive sheet, and is a light transmittance to be measured for all the layers for forming the pressure-sensitive adhesive sheet. A pressure-sensitive adhesive sheet whose light transmittance has been adjusted as described above may be formed by, for example, incorporating a predetermined UV absorber into the gas-generating layer. In the present invention, when the wavelength of light in an ultraviolet region is set within the range (from 360 nm to 380 nm), light having a wavelength of 355 nm to be used as UV laser light is efficiently absorbed, and hence its light energy can be converted into thermal energy. Meanwhile, when the transmittance for light having a wavelength of 380 nm is improved, a photopolymerization initiator having absorption in the wavelength range of from 350 nm to 380 nm can be used in combination with the sheet. Accordingly, when an active energy ray-curable pressure-sensitive adhesive composition is used, active energy ray irradiation (e.g., irradiation with UV light having a wavelength of 380 nm) can cure the gas-generating layer to improve its modulus of elasticity. In such pressure-sensitive adhesive sheet, excessive deformation of its pressure-sensitive adhesive at the time of irradiation with the UV laser light is suppressed, and hence only the small electronic part that needs to be peeled can be peeled. In addition, unnecessary separation of the small electronic part can be prevented. When the transmittances for light having a wavelength of 360 nm and light having a wavelength of 380 nm are specified as described above, UV light having a wavelength of from 350 nm to 380 nm can be preferably used in the curing reaction of the pressure-sensitive adhesive, and hence the modulus of elasticity of the gas-generating layer can be controlled within an optimum range.

The transmittance of the pressure-sensitive adhesive sheet of the present invention for light having a wavelength of 500 nm is preferably from 70% to 100%, more preferably from 75% to 98%, still more preferably from 80% to 95%. When the transmittance falls within such ranges, there can be obtained such a pressure-sensitive adhesive sheet that when an adherend is peeled by laser light irradiation, the adherend serving as a peeling object can be satisfactorily viewed through the pressure-sensitive adhesive sheet.

The haze value of the pressure-sensitive adhesive sheet of the present invention is preferably 70% or less, more preferably 65% or less, still more preferably 50% or less. When the haze value falls within such ranges, there can be obtained such a pressure-sensitive adhesive sheet that when an adherend is peeled by laser light irradiation, deformed portions (e.g., uneven portions) can be produced at any sites of the gas barrier layer, and variation in shape between the deformed portions (e.g., uneven portions) is small. Although the haze value of the pressure-sensitive adhesive sheet is preferably as low as possible, its lower limit is, for example, 0.1% (preferably 0%).

The initial pressure-sensitive adhesive strength of the pressure-sensitive adhesive sheet of the present invention at 23°C when the surface of the pressure-sensitive adhesive sheet (the surface of the gas-generating layer in the form illustrated in FIG. **1(a)** or the gas barrier layer in the form illustrated in FIG. **1(b)**) is bonded to a stainless-steel plate is preferably from 0.3 N/20 mm to 15 N/20 mm, more preferably from 0.5 N/20 mm to 10 N/20 mm. When the initial pressure-sensitive adhesive strength falls within such ranges, a pressure-sensitive adhesive sheet that can satisfactorily hold an adherend can be obtained. In addition, there can be obtained a pressure-sensitive adhesive sheet, which can express its peelability by being irradiated with low-energy laser light, is suppressed from causing an adhesive residue, and is excellent in directivity at the time of its peeling. The pressure-sensitive adhesive strength is measured in conformity with JIS Z 0237:2000. Specifically, the measurement is performed by: reciprocating a 2-kilogram roller once to bond the pressure-sensitive adhesive sheet to the stainless-steel plate (arithmetic average surface roughness Ra: 40±25 nm); leaving the resultant to stand under 23°C for 30 minutes; and then peeling the pressure-sensitive adhesive sheet under the conditions of a peel angle of 180° and a peel rate (tensile rate) of 300 mm/min. Although the pressure-sensitive adhesive strength of the pressure-sensitive adhesive sheet is changed by laser light irradiation, the term "initial pressure-sensitive adhesive strength" as used herein means a pressure-sensitive adhesive strength before the laser light irradiation. In addition, the initial pressure-sensitive adhesive strength and the following pressure-sensitive adhesive strength may each be measured by bonding the gas-generating layer or the gas barrier layer to the stainless-steel plate.

The thickness of the pressure-sensitive adhesive sheet is preferably from 1 μm to 300 μm, more preferably from 5 μm to 200 μm.

In one embodiment, the pressure-sensitive adhesive sheet is used as a carrier sheet for an adherend (e.g., an electronic part). The pressure-sensitive adhesive sheet may be used, for example, as follows: (1) a plurality of ultrasmall parts arranged on any other fixing material are transported and received onto the pressure-sensitive adhesive sheet; and (2) then, UV laser light (e.g., UV laser light having a wavelength of 355 nm) is applied to selectively peel the ultrasmall part present at a desired site.

As described above, the pressure-sensitive adhesive sheet of the present invention shows satisfactory peelability by being irradiated with laser light. The term "satisfactory peelability" as used herein means the following: (1) the sheet can be peeled with low energy; (2) the sheet is suppressed from causing an adhesive residue; and (3) the sheet is excellent in directivity at the time of its peeling. When the sheet can be peeled with low energy, a site irradiated with the laser light can be prevented from deteriorating. When the sheet is suppressed from causing an adhesive residue, an inconvenience in a postprocess can be prevented. When the sheet is excellent in directivity at the time of its peeling, unnecessary chip scattering can be prevented.

B. Gas-generating Layer

The gas-generating layer may be a layer capable of absorbing UV light. The gas-generating layer typically contains a UV absorber. When the UV absorber is incorporated, a gas-generating layer capable of absorbing laser light to gasify can be formed.

The modulus of elasticity of the section of the gas-generating layer measured by the nanoindentation method (hereinafter sometimes referred to simply as "modulus of elasticity of the gas-generating layer measured by the nanoindentation method") is preferably from 0.1 MPa to 10,000 MPa, more preferably from 0.2 MPa to 1,000 MPa, particularly preferably from 0.3 MPa to 800 MPa. When the modulus of elasticity falls within such ranges, an unnecessary escape of the gas generated from the gas-generating layer is prevented, and the pressure-sensitive adhesive sheet (substantially the gas-generating layer) is satisfactorily deformed through laser light irradiation. The modulus of elasticity measured by the nanoindentation method refers to a modulus of elasticity determined from an applied load-indentation depth curve obtained by continuously measuring, during loading and unloading, an applied load to an indenter and an indentation depth when the indenter is pushed into a sample (e.g., a pressure-sensitive adhesive surface). The modulus of elasticity by the nanoindentation method is obtained by: perpendicularly pressing a Berkovich (triangular pyramid-shaped) probe made of diamond against the cut-out section of a layer to be measured; and subjecting the thus obtained displacement-load hysteresis curve to numerical processing with software (TriboScan) included with a measurement apparatus. As used herein, the term "modulus of elasticity" refers to a modulus of elasticity measured with a nanoindenter (Triboindenter TI-950 manufactured by Hysitron, Inc.) by a single indentation method at a predetermined temperature (25°C) under the measurement conditions of an indentation speed of about 500 nm/sec, a drawing speed of about 500 nm/sec, and an indentation depth of about 1,500 nm. The modulus of elasticity of the gas-generating layer may be adjusted on the basis of, for example, the kind of a material contained in the layer, the structure of a base polymer forming the material, and the kind and amount of an additive added to the layer of interest.

The thickness of the gas-generating layer is preferably from 0.1 $\mu$m to 50 $\mu$m, more preferably from 0.5 $\mu$m to 45 $\mu$m, still more preferably from 1 $\mu$m to 42 $\mu$m, particularly preferably from 2 $\mu$m to 40 $\mu$m. When the thickness falls within such ranges, a pressure-sensitive adhesive sheet capable of forming a more satisfactory deformed portion through laser light irradiation can be obtained.

The modulus of elasticity Er(gas) [unit: MPa] of the gas-generating layer measured by the nanoindentation method and the thickness h(gas) [unit: $\mu$m] thereof satisfy the following expression (1).

$$\mathrm{Log}(\mathrm{Er}(\mathrm{gas}) \times 10^6) \geqq 8.01 \times \mathrm{h}(\mathrm{gas})^{-0.116} \cdots (1)$$

In the present invention, the gas-generating layer is configured to satisfy the expression (1), and hence excessive deformation by the gas generated from the gas-generating layer is prevented, and the pressure-sensitive adhesive sheet is satisfactorily deformed through laser light irradiation. When such gas-generating layer is formed, surface deformation in a fine range can be caused without arranging a thick barrier layer as a layer for preventing excessive deformation. More specifically, the surface of the gas-generating layer alone can be deformed, and the gas barrier layer can be flexibly configured.

In one embodiment, the modulus of elasticity Er(gas) [unit: MPa] measured by the nanoindentation method and the thickness h(gas) [unit: $\mu$m] satisfy the following expression (2) . In one embodiment, the modulus of elasticity Er(gas) [unit: MPa] measured by the nanoindentation method and the thickness h(gas) [unit: $\mu$m] satisfy the following expression (3).

$$\mathrm{Log}(\mathrm{Er}(\mathrm{gas}) \times 10^6) \geqq 7.66 \times \mathrm{h}(\mathrm{gas})^{-0.092} \cdots (2)$$

$$\mathrm{Log}\left(\mathrm{Er(gas)}\times10^6\right)\geqq7.52\times\mathrm{h(gas)}^{-0.081}\cdots(3)$$

When the modulus of elasticity and the thickness fall within such ranges, the above-mentioned effects become more remarkable.

In one embodiment, the modulus of elasticity Er(gas) [unit: MPa] measured by the nanoindentation method and the thickness h(gas) [unit: $\mu$m] further satisfy the following expression (4).

$$\mathrm{Log}\left(\mathrm{Er(gas)}\times10^6\right)\leqq47.675\times\mathrm{h(gas)}^{-0.519}\cdots(4)$$

The gasification starting temperature of the gas-generating layer is preferably from 150°C to 500°C, more preferably from 170°C to 450°C, still more preferably from 190°C to 420°C, particularly preferably from 200°C to 400°C. When the gasification starting temperature falls within such ranges, a pressure-sensitive adhesive sheet that can form a more satisfactory deformed portion by being irradiated with laser light can be obtained. The term "gasification starting temperature of the gas-generating layer" as used herein means a gas generation rising temperature calculated from EGA analysis at the time of an increase in temperature of the pressure-sensitive adhesive sheet. The gas generation rising temperature is defined as the temperature at which the half value of the highest gas generation peak of an EGA/MS spectrum obtained from the EGA analysis is achieved. As the gasification starting temperature becomes lower, the temperature at which the gas starts to be generated at the time of the laser light irradiation becomes lower, and hence a sufficient amount of the gas is generated even when the laser light irradiation is performed at a smaller output. In one embodiment, the gasification starting temperature of the gas-generating layer corresponds to the gasification starting temperature of its UV absorber.

The 10% weight loss temperature of the gas-generating layer is preferably from 150°C to 500°C, more preferably from 170°C to 450°C, still more preferably from 200°C to 400°C. When the 10% weight loss temperature falls within such ranges, a pressure-sensitive adhesive sheet that can form a more satisfactory deformed portion by being irradiated with laser light can be obtained. The 10% weight loss temperature of the gas-generating layer means a temperature at the time point when, in TGA analysis at the time of an increase in temperature of the pressure-sensitive adhesive sheet (e.g., at the time of a temperature increase by laser light irradiation), the weight of the gas-generating layer reduces by 10 wt% as compared to the weight thereof before the temperature increase (i.e., the weight of the gas-generating layer becomes 90% of the weight before the temperature increase).

As described above, the gas-generating layer preferably contains the UV absorber. In one embodiment, the gas-generating layer further contains an active energy ray-curable composition (e.g., a pressure-sensitive adhesive). In one embodiment, the gas-generating layer contains a binder resin. The binder resin is preferably a cured product of the active energy ray-curable composition (e.g., a pressure-sensitive adhesive). In one embodiment, the gas-generating layer contains an acrylic polymer.

(UV Absorber)

Any appropriate UV absorber may be used as the UV absorber as long as the compound absorbs UV light (e.g., light having a wavelength of 360 nm or less). Examples of the UV absorber include a benzotriazole-based UV absorber, a benzophenone-based UV absorber, a triazine-based UV absorber, a salicylate-based UV absorber, and a cyanoacrylate-based UV absorber. Of those, a triazine-based UV absorber or a benzotriazole-based UV absorber is preferred, and a triazine-based UV absorber is particularly preferred. In particular, when an acrylic polymer is used as a binder resin, the triazine-based UV absorber may be preferably used because of its high compatibility with the acrylic polymer. The triazine-based UV absorber more preferably includes a compound having a hydroxy group, and is particularly preferably a UV absorber (hydroxyphenyltriazine-based UV absorber) including a hydroxyphenyltriazine-based compound.

Examples of the hydroxyphenyltriazine-based UV absorber include a reaction product of 2-(4,6-bis(2,4-dimethylphenyl)-1,3,5-triazin-2-yl)-5-hydroxyphenyl and a [(C10-C16 (mainly C12-C13) alkyloxy)methyl]oxirane (product name: "TINUVIN 400", manufactured by BASF SE), 2-[4,6-bis(2,4-dimethylphenyl)-1,3,5-triazin-2-yl]-5-[3-(dodecyloxy)-2-hydroxypropoxy]phenol, a reaction product of 2-(2,4-dihydroxyphenyl)-4,6-bis-(2,4-dimethylphenyl)-1,3,5-triazine and (2-ethylhexyl)-glycidic acid ester (product name: "TINUVIN 405", manufactured by BASF SE), 2,4-bis(2-hydroxy-4-butoxyphenyl)-6-(2,4-dibutoxyphenyl)-1,3,5-triazine (product name: "TINUVIN 460", manufactured by BASF SE), 2-(4,6-diphenyl-1,3,5-triazin-2-yl)-5-[(hexyl)oxy]-phenol (product name: "TINUVIN 1577", manufactured by BASF SE), 2-(4,6-diphenyl-1,3,5-triazin-2-yl)-5-[2-(2-ethylhexanoyloxy)ethoxy]-phenol (product name: "ADK STAB LA-46", manufactured by ADEKA Corporation), 2-(2-hydroxy-4-[1-octyloxycarbonylethoxy]phenyl)-4,6-bis(4-phenylphenyl)-1,3,5-triazine (product name: "TINUVIN 479", manufactured by BASF SE), and a product available under the product name "TINUVIN 477" from BASF SE.

Examples of the benzotriazole-based UV absorber (benzotriazole-based compound) include 2-(2-hydroxy-5-tert-butylphenyl)-2H-benzotriazole (product name: "TINUVIN PS", manufactured by BASF SE), an ester compound of benzenepropanoic acid and 3-(2H-benzotriazol-2-yl)-5-(1,1-dimethylethyl)-4-hydroxy (C7-9 side chain and linear alkyl) (product name: "TINUVIN 384-2", manufactured by BASF SE), a mixture of octyl 3-[3-tert-butyl-4-hydroxy-5-(5-chloro-2H-benzotriazol-2-yl)phenyl] propionate and 2-ethylhexyl-3-[3-tert-butyl-4-hydroxy-5-(5-chloro-2H-benzotriazol-2-yl)phenyl] propionate (product name: "TINUVIN 109", manufactured by BASF SE), 2-(2H-benzotriazol-2-yl)-4,6-bis(1-methyl-1-phenylethyl)phenol (product name: "TINUVIN 900", manufactured by BASF SE), 2-(2H-benzotriazol-2-yl)-6-(1-methyl-1-phenylethyl)-4-(1,1,3,3-tetramethylbutyl)phenol (product name: "TINUVIN 928", manufactured by BASF SE), a reaction product of methyl 3-(3-(2H-benzotriazol-2-yl)-5-tert-butyl-4-hydroxyphenyl) propionate/polyethylene glycol 300 (product name: "TINUVIN 1130", manufactured by BASF SE), 2-(2H-benzotriazol-2-yl)-p-cresol (product name: "TINUVIN P", manufactured by BASF SE), 2-(2H-benzotriazol-2-yl)-4,6-bis(1-methyl-1-phenylethyl)phenol (product name: "TINUVIN 234", manufactured by BASF SE), 2-[5-chloro-2H-benzotriazol-2-yl]-4-methyl-6-(tert-butyl)phenol (product name: "TINUVIN 326", manufactured by BASF SE), 2-(2H-benzotriazol-2-yl)-4,6-di-tert-pentylphenol (product name: "TINUVIN 328", manufactured by BASF SE), 2-(2H-benzotriazol-2-yl)-4-(1,1,3,3-tetramethylbutyl)phenol (product name: "TINUVIN 329", manufactured by BASF SE), 2,2'-methylenebis[6-(2H-benzotriazol-2-yl)-4-(1,1,3,3-tetramethylbutyl)phenol] (product name: "TINUVIN 360", manufactured by BASF SE), a reaction product of methyl 3-(3-(2H-benzotriazol-2-yl)-5-tert-butyl-4-hydroxyphenyl) propionate and polyethylene glycol 300 (product name: "TINUVIN 213", manufactured by BASF SE), 2-(2H-benzotriazol-2-yl)-6-dodecyl-4-methylphenol (product name: "TINUVIN 571", manufactured by BASF SE), 2-[2-hydroxy-3-(3,4,5,6-tetrahydrophthalimido-methyl)-5-methylphenyl]benzotriazole (product name: "Sumisorb 250", manufactured by Sumitomo Chemical Co., Ltd.), 2-(3-tert-butyl-2-hydroxy-5-methylphenyl)-5-chloro-2H-benzotriazole (product name: "SEESORB 703", manufactured by Shipro Kasei Kaisha, Ltd.), 2-(2H-benzotriazol-2-yl)-4-methyl-6-(3,4,5,6-tetrahydrophthalimidylmethyl)phenol (product name: "SEESORB 706", manufactured by Shipro Kasei Kaisha, Ltd.), 2-(4-benzoyloxy-2-hydroxyphenyl)-5-chloro-2H-benzotriazole (product name: "SEESORB 7012BA", manufactured by Shipro Kasei Kaisha, Ltd.), 2-tert-butyl-6-(5-chloro-2H-benzotriazol-2-yl)-4-methylphenol (product name: "KEMISORB 73", manufactured by Chemipro Kasei Kaisha, Ltd.), 2,2'-methylenebis[6-(2H-benzotriazol-2-yl)-4-tert-octylphenol] (product name: "ADK STAB LA-31", manufactured by ADEKA Corporation), 2-(2H-benzotriazol-2-yl)-p-cellulose (product name: "ADK STAB LA-32", manufactured by ADEKA Corporation), and 2-(5-chloro-2H-benzotriazol-2-yl)-6-tert-butyl-4-methylphenol (product name: "ADK STAB LA-36", manufactured by ADEKA Corporation).

The UV absorber may be a dye or a pigment. Examples of the pigment include azo-based, phthalocyanine-based, anthraquinone-based, lake-based, perylene-based, perinone-based, quinacridone-based, thioindigo-based, dioxazine-based, isoindolinone-based, and quinophthalone-based pigments. Examples of the dye include azo-based, phthalocyanine-based, anthraquinone-based, carbonyl-based, indigo-based, quinone imine-based, methine-based, quinoline-based, and nitro-based dyes.

The molecular weight of the compound for forming the UV absorber is preferably from 100 to 1,500, more preferably from 200 to 1,200, still more preferably from 200 to 1,000. When the molecular weight falls within such ranges, a pressure-sensitive adhesive sheet that can form a more satisfactory deformed portion through laser light irradiation can be obtained.

In one embodiment, the maximum absorption wavelength of the UV absorber is preferably 360 nm or less, more preferably 355 nm or less, still more preferably 340 nm or less. The use of such UV absorber can provide a pressure-sensitive adhesive sheet that is excellent in characteristic stability under an ordinary state while being preferably capable of absorbing UV light to show satisfactory peelability.

The content of the UV absorber is preferably from 1 part by weight to 50 parts by weight, more preferably from 3 parts by weight to 40 parts by weight with respect to 100 parts by weight of the base polymer in the gas-generating layer.

(Active Energy Ray-curable Composition)

The use of the active energy ray-curable composition enables the formation of a gas-generating layer whose modulus of elasticity is preferably adjusted.

In one embodiment, an active energy ray-curable composition (A1), which contains a base polymer serving as a parent agent and an active energy ray-reactive compound (monomer or oligomer) that can be bonded to the base polymer, is used as the active energy ray-curable composition. In another embodiment, an active energy ray-curable composition (A2) containing an active energy ray-reactive polymer as the base polymer is used. The base polymer preferably has a functional group that can react with a photopolymerization initiator. Examples of the functional group include a hydroxyl group and a carboxyl group.

Examples of the base polymer to be used in the pressure-sensitive adhesive (A1) include: rubber-based polymers, such as a natural rubber, a polyisobutylene rubber, a styrene-butadiene rubber, a styrene-isoprene-styrene block copolymer rubber, a reclaimed rubber, a butyl rubber, a polyisobutylene rubber, and a nitrile rubber (NBR); silicone-based polymers; and acrylic polymers. Those polymers may be used alone or in combination thereof. Of those, an acrylic polymer is preferred.

Examples of the acrylic polymer include: homopolymers or copolymers of hydrocarbon group-containing (meth)acrylic acid esters, such as a (meth)acrylic acid alkyl ester, a (meth)acrylic acid cycloalkyl ester, and a (meth)acrylic acid aryl ester; and copolymers of the hydrocarbon group-containing (meth)acrylic acid esters and other copolymerizable monomers. Examples of the (meth)acrylic acid alkyl ester include (meth)acrylic acid methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, that is, lauryl ester, tridecyl ester, tetradecyl ester, hexadecyl ester, octadecyl ester, and eicosyl ester. Examples of the (meth)acrylic acid cycloalkyl ester include (meth)acrylic acid cyclopentyl ester and cyclohexyl ester. Examples of the (meth)acrylic acid aryl ester include phenyl (meth)acrylate and benzyl (meth)acrylate. The content of a constituent unit derived from the hydrocarbon group-containing (meth)acrylic acid ester is preferably 40 parts by weight or more, more preferably 60 parts by weight or more with respect to 100 parts by weight of the base polymer.

Examples of the other copolymerizable monomer include functional group-containing monomers, such as a carboxy group-containing monomer, an acid anhydride monomer, a hydroxy group-containing monomer, a glycidyl group-containing monomer, a sulfonic acid group-containing monomer, a phosphoric acid group-containing monomer, acrylamide, and acrylonitrile. Examples of the carboxy group-containing monomer include acrylic acid, methacrylic acid, carboxyethyl (meth)acrylate, carboxypentyl (meth)acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate. Examples of the glycidyl group-containing monomer include glycidyl (meth)acrylate and methylglycidyl (meth)acrylate. Examples of the sulfonic acid group-containing monomer include styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid. An example of the phosphoric acid group-containing monomer is 2-hydroxyethylacryloyl phosphate. An example of the acrylamide is N-acryloylmorpholine. Those monomers may be used alone or in combination thereof. The content of a constituent unit derived from the copolymerizable monomer is preferably 60 parts by weight or less, more preferably 40 parts by weight or less with respect to 100 parts by weight of the base polymer.

The acrylic polymer may contain a constituent unit derived from a polyfunctional monomer for forming a cross-linked structure in a polymer skeleton thereof. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylate (that is, polyglycidyl (meth)acrylate), polyester (meth)acrylate, and urethane (meth)acrylate. Those monomers may be used alone or in combination thereof. The content of the constituent unit derived from the polyfunctional monomer is preferably 40 parts by weight or less, more preferably 30 parts by weight or less with respect to 100 parts by weight of the base polymer.

The weight-average molecular weight of the acrylic polymer is preferably from 100,000 to 3,000,000, more preferably from 200,000 to 2,000,000. The weight-average molecular weight may be measured by GPC (solvent: THF).

The active energy ray-reactive compound that may be used in the composition (A1) is, for example, a photoreactive monomer or oligomer having a functional group having a polymerizable carbon-carbon multiple bond, such as an acryloyl group, a methacryloyl group, a vinyl group, an allyl group, or an acetylene group. Specific examples of the photoreactive monomer include esterified products of (meth)acrylic acid and polyhydric alcohols, such as trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, 1,4-butanediol di(meth)acrylate, 1,6-hexanediol di(meth)acrylate, and polyethylene glycol di(meth)acrylate; polyfunctional urethane (meth)acrylate; epoxy (meth)acrylate; and oligoester (meth)acrylates. In addition, a monomer, such as methacryloisocyanate, 2-methacryloyloxyethyl isocyanate (2-isocyanatoethyl methacrylate), or m-isopropenyl-$\alpha,\alpha$-dimethylbenzyl isocyanate, may be used. Specific examples of the photoreactive oligomer include dimers to pentamers of the above-mentioned monomers. The molecular weight of the photoreactive oligomer is preferably from 100 to 3,000.

In addition, a monomer, such as epoxidized butadiene, glycidyl methacrylate, acrylamide, or vinylsiloxane, or an oligomer formed of the monomer may be used as the active energy ray-reactive compound.

Further, a mixture of an organic salt, such as an onium salt, and a compound having a plurality of heterocycles in a molecule thereof may be used as the active energy ray-reactive compound. When the mixture is irradiated with an active energy ray (e.g., UV light or an electron beam), the organic salt cleaves to produce an ion, and the ion serves as an initiation species to cause the ring-opening reaction of the heterocycles. Thus, a three-dimensional network structure can be formed. Examples of the organic salt include an iodonium salt, a phosphonium salt, an antimonium salt, a sulfonium salt, and a borate salt. Examples of the heterocycles in the compound having the plurality of heterocycles in a molecule thereof include oxirane, oxetane, oxolane, thiirane, and aziridine.

The content of the active energy ray-reactive compound in the composition (A1) is preferably from 0.1 part by weight to 500 parts by weight, more preferably from 5 parts by weight to 300 parts by weight, still more preferably from 40 parts by weight to 150 parts by weight with respect to 100 parts by weight of the base polymer.

The active energy ray-reactive polymer (base polymer) in the composition (A2) is, for example, a polymer having a functional group having a carbon-carbon multiple bond, such as an acryloyl group, a methacryloyl group, a vinyl group, an allyl group, or an acetylene group. Specific examples of the active energy ray-reactive polymer include: polymers formed of polyfunctional (meth)acrylates; photocationically polymerizable polymers; cinnamoyl group-containing polymers, such as polyvinyl cinnamate; diazotized amino novolac resins; and polyacrylamide.

In one embodiment, there is used an active energy ray-reactive polymer formed by introducing an active energy ray-polymerizable carbon-carbon multiple bond into a side chain of the above-mentioned acrylic polymer, the main chain thereof, and/or a terminal of the main chain. An approach to introducing a radiation-polymerizable carbon-carbon double bond into the acrylic polymer is, for example, a method including: copolymerizing raw material monomers including a monomer having a predetermined functional group (first functional group) to provide the acrylic polymer; and then subjecting a compound having a predetermined functional group (second functional group) that can react with the first functional group to be bonded thereto and the radiation-polymerizable carbon-carbon double bond to a condensation reaction or an addition reaction with the acrylic polymer while maintaining the radiation polymerizability of the carbon-carbon double bond.

Examples of the combination of the first functional group and the second functional group include: a carboxy group and an epoxy group; an epoxy group and a carboxy group; a carboxy group and an aziridyl group; an aziridyl group and a carboxy group; a hydroxy group and an isocyanate group; and an isocyanate group and a hydroxy group. Of those combinations, the combination of a hydroxy group and an isocyanate group or the combination of an isocyanate group and a hydroxy group is preferred from the viewpoint of the ease with which a reaction between the groups is tracked. In addition, technical difficulty in producing a polymer having an isocyanate group having high reactivity is high, and hence a case in which the first functional group of the acrylic polymer side is a hydroxy group and the second functional group is an isocyanate group is more preferred from the viewpoint of the ease with which the acrylic polymer is produced or obtained. In this case, examples of an isocyanate compound having both of a radiation-polymerizable carbon-carbon double bond and an isocyanate group serving as the second functional group include methacryloyl isocyanate, 2-methacryloyloxyethyl isocyanate, and m-isopropenyl-$\alpha,\alpha$-dimethylbenzyl isocyanate. In addition, a polymer containing a constituent unit derived from the above-mentioned hydroxy group-containing monomer is preferred as the acrylic polymer having the first functional group, and a polymer containing a constituent unit derived from an ether-based compound, such as 2-hydroxyethyl vinyl ether, 4-hydroxybutyl vinyl ether, or diethylene glycol monovinyl ether, is also preferred.

The composition (A2) may further contain the active energy ray-reactive compound (monomer or oligomer).

The active energy ray-curable composition may contain a photopolymerization initiator.

Any appropriate initiator may be used as the photopolymerization initiator. Examples of the photopolymerization initiator include: $\alpha$-ketol-based compounds, such as 4-(2-hydroxyethoxy)phenyl (2-hydroxy-2-propyl)ketone, $\alpha$-hydroxy-$\alpha,\alpha$'-dimethylacetophenone, 2-methyl-2-hydroxypropiophenone, and 1-hydroxycyclohexyl phenyl ketone; acetophenone-based compounds, such as methoxyacetophenone, 2,2-dimethoxy-2-phenylacetophenone, 2,2-diethoxyacetophenone, and 2-methyl-1-[4-(methylthio)-phenyl]-2-morpholinopropane-1; benzoin ether-based compounds, such as benzoin ethyl ether, benzoin isopropyl ether, and anisoin methyl ether; ketal-based compounds, such as benzyl dimethyl ketal; aromatic sulfonyl chloride-based compounds, such as 2-naphthalenesulfonyl chloride; photoactive oxime-based compounds, such as 1-phenone-1,1-propanedione-2-(o-ethoxycarbonyl)oxime; benzophenone-based compounds, such as benzophenone, benzoylbenzoic acid, and 3,3'-dimethyl-4-methoxybenzophenone; thioxanthone-based compounds, such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; acylphosphinoxides; and acylphosphonates. The usage amount of the photopolymerization initiator may be set to any appropriate amount.

In one embodiment, a photopolymerization initiator having an absorption coefficient of from 10 ml/g·cm to 10,000 ml/g·cm (preferably from 80 ml/g·cm to 8,000 ml/g·cm, more preferably from 100 ml/g·cm to 5,000 ml/g·cm) for light having a wavelength of 365 nm is used. In the present invention, when the gas-generating layer is formed so that the transmittance of the pressure-sensitive adhesive sheet for light having a wavelength of 360 nm may be from 0% to 35%, a photopolymerization initiator having high reactivity in a middle wavelength region (e.g., from 360 nm to 380 nm) can be adopted. The gas-generating layer containing such photopolymerization initiator is advantageous in that its characteristics hardly change in a situation where the layer should not be cured, for example, at the time of its storage or at the time of its use under a UV-cut lamp. The light absorption coefficient as used herein means a light absorption coefficient in methanol. The light absorption coefficient may be measured with a UV-visible-near infrared spectrophotometer (product name: "V-570", manufactured by JASCO Corporation) after the preparation of a solution of the photopolymerization initiator in methanol.

In one embodiment, the absorption coefficient of the photopolymerization initiator for light having a wavelength of 405 nm is preferably 10 ml/g·cm or less, more preferably 8 ml/g·cm or less.

A commercially available product may be used as the photopolymerization initiator. Examples of the photopolymerization initiator include products available under the product names "IRGACURE 651", "IRGACURE 184", "IRGACURE 1173", "IRGACURE 500", "IRGACURE 2959", "IRGACURE 127", "IRGACURE 754", "IRGACURE MBF", and "IRGACURE 907" from BASF SE.

The content of the photopolymerization initiator is preferably from 0.1 part by weight to 20 parts by weight, more preferably from 0.5 part by weight to 15 parts by weight with respect to 100 parts by weight of the base polymer in the pressure-sensitive adhesive.

The active energy ray-curable composition preferably contains a cross-linking agent. Examples of the cross-linking agent include an isocyanate-based cross-linking agent, an epoxy-based cross-linking agent, an oxazoline-based cross-linking agent, an aziridine-based cross-linking agent, a melamine-based cross-linking agent, a peroxide-based cross-linking agent, a urea-based cross-linking agent, a metal alkoxide-based cross-linking agent, a metal chelate-based cross-linking agent, a metal salt-based cross-linking agent, a carbodiimide-based cross-linking agent, and an amine-based cross-linking agent.

The content of the cross-linking agent is preferably from 0.1 part by weight to 15 parts by weight, more preferably from 0.2 part by weight to 12 parts by weight with respect to 100 parts by weight of the base polymer in the active energy ray-curable composition.

In one embodiment, an isocyanate-based cross-linking agent is preferably used. The isocyanate-based cross-linking agent is preferred because the agent may react with many kinds of functional groups. Specific examples of the isocyanate-based cross-linking agent include: lower aliphatic polyisocyanates, such as butylene diisocyanate and hexamethylene diisocyanate; alicyclic isocyanates, such as cyclopentylene diisocyanate, cyclohexylene diisocyanate, and isophorone diisocyanate; aromatic isocyanates, such as 2,4-tolylene diisocyanate, 4,4'-diphenylmethane diisocyanate, and xylylene diisocyanate; and isocyanate adducts, such as a trimethylolpropane/tolylene diisocyanate trimer adduct (manufactured by Nippon Polyurethane Industry Co., Ltd., product name: "Coronate L"), a trimethylolpropane/hexamethylene diisocyanate trimer adduct (manufactured by Nippon Polyurethane Industry Co., Ltd., product name: "Coronate HL"), and an isocyanurate form of hexamethylene diisocyanate (manufactured by Nippon Polyurethane Industry Co., Ltd., product name: "Coronate HX"). Of those, a cross-linking agent having 3 or more isocyanate groups is preferably used.

The active energy ray-curable composition may further contain any appropriate additive as required. Examples of the additive include an active energy ray polymerization accelerator, a radical scavenger, a tackifier, a plasticizer (e.g., a trimellitate-based plasticizer or a pyromellitate-based plasticizer), a pigment, a dye, a filler, an age resistor, a conductive material, an antistatic agent, a UV absorber, a light stabilizer, a peeling modifier, a softener, a surfactant, a flame retardant, and an antioxidant.

C. Gas Barrier Layer

The modulus of elasticity of the gas barrier layer measured by the nanoindentation method is preferably from 0.1 MPa to 100 MPa, more preferably from 0.2 MPa to 50 MPa, still more preferably from 0.3 MPa to 35 MPa.

The thickness of the gas barrier layer is preferably from 0.1 $\mu$m to 50 $\mu$m, more preferably from 0.2 $\mu$m to 45 $\mu$m, still more preferably from 0.3 $\mu$m to 40 $\mu$m. In the present invention, even when the pressure-sensitive adhesive sheet includes a thin and soft gas barrier layer, the deformation of its surface can be preferably caused by laser light irradiation.

The gas barrier layer may contain any appropriate pressure-sensitive adhesive. A pressure-sensitive adhesive A having pressure sensitivity is preferably used as the pressure-sensitive adhesive A contained in the gas barrier layer. Examples of the pressure-sensitive adhesive A include an acrylic pressure-sensitive adhesive, a rubber-based pressure-sensitive adhesive, a vinyl alkyl ether-based pressure-sensitive adhesive, a silicone-based pressure-sensitive adhesive, a polyester-based pressure-sensitive adhesive, a polyamide-based pressure-sensitive adhesive, a urethane-based pressure-sensitive adhesive, and a styrene-diene block copolymer-based pressure-sensitive adhesive. Of those, an acrylic pressure-sensitive adhesive or a rubber-based pressure-sensitive adhesive is preferred, and an acrylic pressure-sensitive adhesive is more preferred. The pressure-sensitive adhesives may be used alone or in combination thereof.

An example of the acrylic pressure-sensitive adhesive is an acrylic pressure-sensitive adhesive containing, as a base polymer, an acrylic polymer (homopolymer or copolymer) using one or two or more kinds of (meth) acrylic acid alkyl esters as a monomer component. Specific examples of the (meth)acrylic acid alkyl ester include (meth)acrylic acid Cl-20 alkyl esters, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. Of those, a (meth)acrylic acid alkyl ester having a linear or branched alkyl group having 4 to 18 carbon atoms may be preferably used.

The acrylic polymer may contain a unit corresponding to any other monomer component copolymerizable with the (meth)acrylic acid alkyl ester, as required, for the purpose of modification of cohesive strength, heat resistance, cross-linkability, or the like. Examples of such monomer component include: carboxyl group-containing monomers, such as acrylic acid, methacrylic acid, carboxyethyl acrylate, carboxypentyl acrylate, itaconic acid, maleic acid, fumaric acid, and crotonic acid; acid anhydride monomers, such as maleic anhydride and itaconic anhydride; hydroxyl group-containing monomers, such as hydroxyethyl (meth)acrylate, hydroxypropyl (meth)acrylate, hydroxybutyl (meth)acrylate, hydroxyhexyl (meth)acrylate, hydroxyoctyl (meth)acrylate, hydroxydecyl (meth)acrylate, hydroxylauryl (meth)acrylate, and (4-hydroxymethylcyclohexyl)methyl methacrylate; sulfonic acid group-containing monomers, such as styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; (N-substituted) amide-based monomers, such as (meth)acrylamide, N,N-dimethyl(meth)acrylamide, N-butyl(meth)acrylamide, N-methylol (meth)acrylamide, and N-methylolpropane (meth)acrylamide; aminoalkyl (meth)acrylate-based monomers, such as aminoethyl (meth)acrylate, N,N-dimethylaminoethyl (meth)acrylate, and t-butylaminoethyl (meth)acrylate; alkoxyalkyl (meth)acrylate-based monomers, such as methoxyethyl (meth)acrylate and ethoxyethyl (meth)acrylate; maleimide-based monomers, such as N-cyclohexylmaleimide, N-isopropylmaleimide, N-laurylmaleimide, and N-phenylmaleimide; itaconimide-based monomers, such as N-methyl itaconimide, N-ethyl itaconimide, N-butyl itaconimide, N-octyl itaconimide, N-2-ethylhexyl itaconimide, N-cyclohexyl itaconimide, and N-lauryl itaconimide; succinimide-based monomers, such as N-(meth)acryloyloxymethylene succinimide, N-(meth)acryloyl-6-oxyhexamethylene succinimide, and N-(meth)acryloyl-8-oxyoctamethylene succinimide; vinyl-based monomers, such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinylcarboxylic acid amides, styrene, α-methylstyrene, and N-vinylcaprolactam; cyanoacrylate monomers, such as acrylonitrile and methacrylonitrile; epoxy group-containing acrylic monomers, such as glycidyl (meth)acrylate; glycol-based acrylic ester monomers, such as polyethylene glycol (meth)acrylate, polypropylene glycol (meth)acrylate, methoxyethylene glycol (meth)acrylate, and methoxypolypropylene glycol (meth)acrylate; acrylic acid ester-based monomers each having, for example, a heterocycle, a halogen atom, or a silicon atom, such as tetrahydrofurfuryl (meth)acrylate, fluorine (meth)acrylate, and silicone (meth)acrylate; polyfunctional monomers, such as hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylate, polyester acrylate, and urethane acrylate; olefin-based monomers, such as isoprene, butadiene, and isobutylene; and vinyl ether-based monomers, such as vinyl ether. Those monomer components may be used alone or in combination thereof.

The rubber-based pressure-sensitive adhesive is, for example, a rubber-based pressure-sensitive adhesive including, as a base polymer, a natural rubber, or a synthetic rubber, such as a polyisoprene rubber, a styrene-butadiene (SB) rubber, a styrene-isoprene (SI) rubber, a styrene-isoprene-styrene block copolymer (SIS) rubber, a styrene-butadiene-styrene block copolymer (SBS) rubber, a styrene-ethylene-butylene-styrene block copolymer (SEBS) rubber, a styrene-ethylene-propylene-styrene block copolymer (SEPS) rubber, a styrene-ethylenepropylene block copolymer (SEP) rubber, a reclaimed rubber, a butyl rubber, polyisobutylene, or a modified product thereof.

The pressure-sensitive adhesive A may contain any appropriate additive as required. Examples of the additive include a cross-linking agent, a tackifier (e.g., a rosin-based tackifier, a terpene-based tackifier, or a hydrocarbon-based tackifier), a plasticizer (e.g., a trimellitic acid ester-based plasticizer or a pyromellitic acid ester-based plasticizer), a pigment, a dye, an age resistor, a conductive material, an antistatic agent, a light stabilizer, a peeling modifier, a softener, a surfactant, a flame retardant, and an antioxidant.

Examples of the cross-linking agent include an isocyanate-based cross-linking agent, an epoxy-based cross-linking agent, a melamine-based cross-linking agent, a peroxide-based cross-linking agent, a urea-based cross-linking agent, a metal alkoxide-based cross-linking agent, a metal chelate-based cross-linking agent, a metal salt-based cross-linking agent, a carbodiimide-based cross-linking agent, an oxazoline-based cross-linking agent, an aziridine-based cross-linking agent, and an amine-based cross-linking agent. Of those, an isocyanate-based cross-linking agent or an epoxy-based cross-linking agent is preferred.

Specific examples of the isocyanate-based cross-linking agent include: lower aliphatic polyisocyanates, such as butylene diisocyanate and hexamethylene diisocyanate; alicyclic isocyanates, such as cyclopentylene diisocyanate, cyclohexylene diisocyanate, and isophorone diisocyanate; aromatic isocyanates, such as 2,4-tolylene diisocyanate, 4,4'-diphenylmethane diisocyanate, and xylylene diisocyanate; and isocyanate adducts, such as a trimethylolpropane/tolylene diisocyanate trimer adduct (manufactured by Nippon Polyurethane Industry Co., Ltd., product name "Coronate L"), a trimethylolpropane/hexamethylene diisocyanate trimer adduct (manufactured by Nippon Polyurethane Industry Co., Ltd., product name "Coronate HL"), and an isocyanurate form of hexamethylene diisocyanate (manufactured by Nippon Polyurethane Industry Co., Ltd., product name "Coronate HX"). The content of the isocyanate-based cross-linking agent may be set to any appropriate amount depending on the desired pressure-sensitive adhesive strength, and is typically from 0.1 part by weight to 20 parts by weight, more preferably from 0.5 part by weight to 10 parts by weight with respect to 100 parts by weight of the base polymer.

Examples of the epoxy-based cross-linking agent include N,N,N',N'-tetraglycidyl-m-xylenediamine, diglycidylaniline, 1,3-bis(N,N-glycidylaminomethyl)cyclohexane (manufactured by Mitsubishi Gas Chemical Company, Inc., product name "TETRAD-C"), 1,6-hexanediol diglycidyl ether (manufactured by Kyoeisha Chemical Co., Ltd., product name "Epolite 1600"), neopentyl glycol diglycidyl ether (manufactured by Kyoeisha Chemical Co., Ltd., product name "Epolite 1500NP"), ethylene glycol diglycidyl ether (manufactured by Kyoeisha Chemical Co., Ltd., product name "Epolite 40E"), propylene glycol diglycidyl ether (manufactured by Kyoeisha Chemical Co., Ltd., product name "Epolite 70P"), polyethylene glycol diglycidyl ether (manufactured by NOF Corporation, product name "EPIOL E-400"), polypropylene glycol diglycidyl ether (manufactured by NOF Corporation, product name "EPIOL P-200"), sorbitol polyglycidyl ether (manufactured by Nagase ChemteX Corporation, product name "Denacol EX-611"), glycerol polyglycidyl ether (manufactured by Nagase ChemteX Corporation, product name "Denacol EX-314"), pentaerythritol polyglycidyl ether, polyglycerol polyglycidyl ether (manufactured by Nagase ChemteX Corporation, product name "Denacol EX-512"), sorbitan polyglycidyl ether, trimethylolpropane polyglycidyl ether, adipic acid diglycidyl ester, o-phthalic acid diglycidyl ester, triglycidyl-tris(2-hydroxyethyl) isocyanurate, resorcin diglycidyl ether, bisphenol-S-diglycidyl ether, and an epoxy-based resin having two or more epoxy groups in a molecule thereof. The content of the epoxy-based cross-linking agent may be set to any appropriate amount depending on the desired pressure-sensitive adhesive strength, and is typically from 0.01 part by weight to 10 parts by weight, more preferably from 0.03 part by weight to 5 parts by weight with respect to 100 parts by weight of the base polymer.

### D. Pressure-sensitive Adhesive Layer

Any appropriate pressure-sensitive adhesive may be used as a pressure-sensitive adhesive for forming the pressure-sensitive adhesive layer arranged on the side of the base material opposite to the gas-generating layer as long as the effects of the present invention are obtained. Examples of the pressure-sensitive adhesive include an acrylic pressure-sensitive adhesive, a silicone-based pressure-sensitive adhesive, a vinyl alkyl ether-based pressure-sensitive adhesive, a polyester-based pressure-sensitive adhesive, a polyamide-based pressure-sensitive adhesive, a urethane-based pressure-sensitive adhesive, a fluorine-based pressure-sensitive adhesive, a styrene-diene block copolymer-based pressure-sensitive adhesive, and an active energy ray-curable pressure-sensitive adhesive. Of those, an acrylic pressure-sensitive adhesive, a rubber-based pressure-sensitive adhesive, or a silicone-based pressure-sensitive adhesive is preferred, and an acrylic pressure-sensitive adhesive is more preferred.

A pressure-sensitive adhesive strength at 23°C when the pressure-sensitive adhesive layer of the pressure-sensitive adhesive sheet is bonded to a polyethylene terephthalate film is preferably from 0.01 N/20 mm to 15 N/20 mm, more preferably from 0.05 N/20 mm to 10 N/20 mm.

The transmittance of the pressure-sensitive adhesive layer for light having a wavelength of 355 nm is preferably 70% or more, more preferably 80% or more, still more preferably 90% or more, particularly preferably 95% or more. The upper limit of the transmittance of the pressure-sensitive adhesive layer for light having a wavelength of 355 nm is, for example, 98% (preferably 99%).

### E. Base Material

The base material may include any appropriate resin. Examples of the resin include a polyolefin-based resin, such as a polyethylene-based resin, a polypropylene-based resin, a polybutene-based resin, or a polymethylpentene-based resin, a polyurethane-based resin, a polyester-based resin, a polyimide-based resin, a polyetherketone-based resin, a polystyrene-based resin, a polyvinyl chloride-based resin, a polyvinylidene chloride-based resin, a fluorine-based resin, a silicon-based resin, a cellulose-based resin, and an ionomer resin. Of those, a polyolefin-based resin is preferred.

The thickness of the base material is preferably from 2 $\mu$m to 300 $\mu$m, more preferably from 2 $\mu$m to 100 $\mu$m, still more preferably from 2 $\mu$m to 50 $\mu$m.

The transmittance of the base material for light having a wavelength of 355 nm is preferably 70% or more, more preferably 80% or more, still more preferably 90% or more, particularly preferably 95% or more. The upper limit of the total light transmittance of the base material is, for example, 98% (preferably 99%).

### F. Method of producing Pressure-sensitive Adhesive Sheet

The pressure-sensitive adhesive sheet of the present invention may be produced by any appropriate method. The pressure-sensitive adhesive sheet of the present invention may be obtained by, for example, directly applying (applying and curing) a composition for forming a gas-generating layer containing the active energy ray-curable composition and the UV absorber onto a predetermined base material to form the gas-generating layer. In addition, when the pressure-sensitive adhesive sheet includes the gas barrier layer, the pressure-sensitive adhesive sheet may be obtained by applying a composition for forming a gas barrier layer containing the pressure-sensitive adhesive A onto the gas-generating layer. In addition, the pressure-sensitive adhesive sheet may be formed by separately forming the respective layers and then bonding the layers to each other.

Any appropriate application method may be adopted as an application method for each of the above-mentioned compositions. For example, each layer may be formed by application, followed by drying. Examples of the application method include application methods each using a multicoater, a die coater, a gravure coater, an applicator, or the like. As a drying method, there are given, for example, natural drying and drying by heating. When the drying by heating is performed, a heating temperature may be set to any appropriate temperature depending on the characteristics of a substance to be dried. In addition, active energy ray irradiation (e.g., UV irradiation) may be performed depending on the form of each layer.

### G. Method of processing Electronic Part

A method of treating an electronic part of the present invention includes: bonding an electronic part onto the pressure-sensitive adhesive sheet; and peeling the electronic part from the pressure-sensitive adhesive sheet by irradiating the pressure-sensitive adhesive sheet with laser light. Examples of the electronic part include a semiconductor chip, a LED chip, and a MLCC.

The peeling of the electronic part is performed in a position-selective manner. Specifically, it may be appropriate that a plurality of electronic parts be bonded and fixed to the pressure-sensitive adhesive sheet, and the peeling of the electronic parts be performed so that some of the electronic parts may be peeled and the other electronic part(s) may remain fixed.

In one embodiment, the method of treating an electronic part of the present invention further includes subjecting the electronic part to a predetermined treatment after the bonding of the electronic part onto the pressure-sensitive adhesive sheet and before the peeling of the electronic part from the pressure-sensitive adhesive sheet. The treatment is not particularly limited, and examples thereof include treatments, such as grinding processing, dicing processing, die bonding, wire bonding, etching, vapor deposition, molding, circuit formation, inspection, a product check, cleaning, transfer, arrangement, repair, or protection of a device surface.

The size of the electronic part (area of the bonding surface thereof) is, for example, from 1 $\mu m^2$ to 250,000 $\mu m^2$. In one embodiment, such an electronic part that the size of the electronic part (area of the bonding surface thereof) is from 1 $\mu m^2$ to 6,400 $\mu m^2$ may be subjected to the treatment. In another embodiment, such an electronic part that the size of the electronic part (area of the bonding surface thereof) is from 1 $\mu m^2$ to 2,500 $\mu m^2$ may be subjected to the treatment.

In one embodiment, as described above, a plurality of electronic parts may be arranged on the pressure-sensitive adhesive sheet. An interval between the electronic parts is, for example, from 1 $\mu m$ to 500 $\mu m$. In the present invention, there is an advantage in that the bodies to be treated can be temporarily fixed at a small interval.

For example, UV laser light may be used as the laser light. The irradiation output of the laser light is, for example, from 1 $\mu J$ to 1,000 $\mu J$. The wavelength of the UV laser light is, for example, from 240 nm to 380 nm.

In one embodiment, the method of treating an electronic part includes placing the electronic part on another sheet (e.g., a pressure-sensitive adhesive sheet or a substrate) after the peeling of the electronic part.

### Examples

Now, the present invention is specifically described by way of Examples. However, the present invention is by no means limited to these Examples. Test and evaluation methods in Examples are as described below. In addition, the terms "part(s)" and "%" are by weight unless otherwise stated.

### (1) Initial Pressure-sensitive Adhesive Strength

The gas barrier layer (gas-generating layer in Example 17) of a pressure-sensitive adhesive sheet was bonded to SUS304BA, and the pressure-sensitive adhesive strength of the pressure-sensitive adhesive sheet to the SUS304BA was measured by a method in conformity with JIS Z 0237:2000 (bonding condition: one reciprocation of a 2-kilogram roller, tensile rate: 300 mm/min, peel angle: 180°, measurement temperature: 23°C). In addition, the gas barrier layer (gas-generating layer in Example 17) of the pressure-sensitive adhesive sheet was bonded and fixed to a support such as a stainless-steel plate, and a pressure-sensitive adhesive layer arranged on the side of the base material of the sheet opposite to the gas-generating layer thereof was bonded to a polyethylene terephthalate film (manufactured by Toray Industries, Inc., product name: "LUMIRROR S10", thickness: 25 $\mu$m), followed by the measurement of the pressure-sensitive adhesive strength of the pressure-sensitive adhesive layer by the method in conformity with JIS Z 0237:2000 (bonding condition: one reciprocation of a 2-kilogram roller, tensile rate: 300 mm/min, peel angle: 180°, measurement temperature: 23°C).

(2) Light Transmittance

The pressure-sensitive adhesive sheet was set in a spectrophotometer (product name: "UV-VIS SPECTROPHOTOMETER SolidSpec 3700", manufactured by Shimadzu Corporation), and its light transmittance in the wavelength region of from 300 nm to 800 nm was measured while incident light was adapted to vertically enter the gas barrier layer side of the sample. Transmittances at wavelengths of 360 nm, 380 nm, and 500 nm in the resultant transmission spectrum were sampled.

(3-1) Change in Surface Shape of Pressure-sensitive Adhesive Sheet

The pressure-sensitive adhesive layer side of the pressure-sensitive adhesive sheet was bonded to a glass plate (manufactured by Matsunami Glass Ind., Ltd., Large Slide Glass S9112 (standard, large-sized, WHITE EDGE GRINDING No. 2)) to provide a measurement sample. The glass plate side of the measurement sample was pulse-scanned with UV laser light having a wavelength of 355 nm and a beam diameter of about 20 $\mu$m$\varphi$ at an output of 0.80 mW and a frequency of 40 kHz to generate a gas from the gas-generating layer. A change in shape of the surface of the pressure-sensitive adhesive sheet (the surface of the gas barrier layer or the surface of the gas-generating layer in Example 17) caused by such operation was observed.

(3-2) Change in Surface Shape of Pressure-sensitive Adhesive Sheet (Peelability and Position Selectivity of Peeling)

A glass plate (manufactured by Matsunami Glass Ind., Ltd., Large Slide Glass S9112 (standard, large-sized, WHITE EDGE GRINDING No. 2)) was bonded to the pressure-sensitive adhesive layer side of a pressure-sensitive adhesive sheet to provide a measurement sample. The measurement sample was subjected to a pulse scan from its glass plate side with UV laser light having a wavelength of 355 nm and a beam diameter of about 20 $\mu$m$\varphi$ at an output of 0.80 mW and a frequency of 40 kHz to generate a gas from the gas-generating layer. The surface of the gas barrier layer (the surface of the gas-generating layer in Example 17) corresponding to any appropriate one spot subjected to the pulse scan was observed with a confocal laser microscope after 1 minute from the laser light irradiation, and a vertical displacement Y and a horizontal displacement X (diameter; full width at half maximum) were measured.

When the displacement Y is 1 $\mu$m or more, the peelability is excellent (Symbol "∘" in the tables), when the displacement Y is 0.6 $\mu$m or more and less than 1 $\mu$m, the peelability is satisfactory (Symbol "Δ" in the tables), and when the displacement Y is less than 0.6 $\mu$m, the peelability is insufficient (Symbol "x" in the tables). When the displacement X is 50 $\mu$m or less, the position selectivity of peeling is excellent (Symbol "∘" in the tables), and when the displacement X is more than 50 $\mu$m, the position selectivity of the peeling is insufficient (Symbol "×" in the tables).

(4) Haze Value

The haze value of the pressure-sensitive adhesive sheet was measured with a haze meter (product name: "HAZE METER HM-150", manufactured by Murakami Color Research Laboratory Co., Ltd.) .

(5) 10% Weight Loss Temperature

The 10% weight loss temperature of a UV absorber was measured.
The temperature at which the weight of the absorber reduced by 10% was measured with a differential thermal analyzer (manufactured by TA Instruments, Inc., product name: "Discovery TGA") while the temperature of the pressure-sensitive adhesive sheet was increased at a rate of temperature increase of 10°C/min under a $N_2$ atmosphere at a flow rate of 25 ml/min.

(6) Modulus of Elasticity

The modulus of elasticity of the pressure-sensitive adhesive sheet was measured with a nanoindenter (Triboindenter TI-950 manufactured by Hysitron, Inc.) by a single indentation method at a predetermined temperature (25°C) under the measurement conditions of an indentation speed of about 500 nm/sec, a pulling speed of about 500 nm/sec, and an indentation depth of about 1,500 nm.

[Production Example 1] Production of Acrylic Polymer I

95 Parts by weight of 2-ethylhexyl acrylate, 5 parts by weight of acrylic acid, and 0.15 part by weight of benzoyl peroxide serving as a polymerization initiator were added to ethyl acetate, and then the mixture was heated to 70°C to provide a solution of an acrylic copolymer (acrylic polymer I) in ethyl acetate.

[Production Example 2] Production of Acrylic Polymer II

100 Parts by weight of 2-ethylhexyl acrylate, 12.6 parts by weight of 2-hydroxyethyl acrylate, and 0.25 part by weight of benzoyl peroxide serving as a polymerization initiator were added to toluene. After that, the mixture was subjected to a polymerization reaction in a stream of a nitrogen gas at 60°C, and 13.5 parts of methacryloyloxyethyl isocyanate was added to the resultant to perform an addition reaction. Thus, a solution of an acrylic copolymer having a carbon-carbon double bond (acrylic polymer II) in toluene was obtained.

[Example 1]

(Preparation of Pressure-sensitive Adhesive A(1) for forming Gas Barrier Layer)

1 Part by weight of an epoxy-based cross-linking agent (manufactured by Mitsubishi Gas Chemical Company, Inc., product name: "TETRAD-C") and 3 parts by weight of an isocyanate-based cross-linking agent (manufactured by Nippon Polyurethane Industry Co., Ltd., product name: "Coronate L") were added to the solution I of the acrylic polymer in ethyl acetate containing 100 parts by weight of the acrylic polymer I to prepare a pressure-sensitive adhesive A(1) for forming a gas barrier layer.

(Preparation of Composition for forming Gas-generating Layer)

0.2 Part by weight of an isocyanate-based cross-linking agent (manufactured by Nippon Polyurethane Industry Co., Ltd., product name: "Coronate L"), 3 parts by weight of a photopolymerization initiator (manufactured by BASF SE, product name: "Irgacure 127"), and 20 parts by weight of a UV absorber (manufactured by BASF SE, product name: "Tinuvin 400") were added to the solution I of the acrylic polymer in toluene containing 100 parts by weight of the acrylic polymer II to prepare a composition (1) for forming a gas-generating layer.

(Preparation of Pressure-sensitive Adhesive (2))

2 Parts by weight of an epoxy-based cross-linking agent (manufactured by Mitsubishi Gas Chemical Company, Inc., product name: "TETRAD-C") was added to the solution I of the acrylic polymer in ethyl acetate containing 100 parts by weight of the acrylic polymer I to prepare a pressure-sensitive adhesive (2).

(Pressure-sensitive Adhesive Sheet)

The pressure-sensitive adhesive (2) was applied to one surface of a polyethylene terephthalate film (manufactured by Toray Industries, Inc., product name: "LUMIRROR S10", thickness: 50 $\mu$m) so that its thickness after solvent volatilization (drying) became 10 $\mu$m. Thus, a pressure-sensitive adhesive layer was formed.
Next, the composition (1) for forming a gas-generating layer was applied to the other surface of the polyethylene terephthalate film (manufactured by Toray Industries, Inc., product name: "LUMIRROR S10", thickness: 50 $\mu$m) so that its thickness after solvent volatilization (drying) became 10 $\mu$m. Thus, a precursor layer of a gas-generating layer was formed.
Next, the pressure-sensitive adhesive A(1) for forming a gas barrier layer was applied to a polyethylene terephthalate film with a silicone release agent-treated surface (manufactured by Toray Industries, Inc., product name: "CERAPEEL", thickness: 38 $\mu$m) so that its thickness after solvent volatilization (drying) became 10 $\mu$m. Thus, a gas barrier layer was formed.
Next, the precursor layer of the gas-generating layer and the gas barrier layer were laminated to provide a pressure-sensitive adhesive sheet precursor (gas barrier layer/gas-generating layer/base material) sandwiched between the polyethylene terephthalate film with a silicone release agent-treated surface and the polyethylene terephthalate film. UV light having an integrated light quantity of 500 mJ/cm$^2$ was applied through the polyethylene terephthalate film with a silicone release agent-treated surface on the gas barrier layer side of the pressure-sensitive adhesive sheet precursor to provide a pressure-sensitive adhesive sheet. The UV irradiation was performed by irradiating the gas-generating layer with the UV light of a high-pressure mercury lamp (characteristic wavelength: 365 nm, integrated light quantity: 500

mJ/cm$^2$, irradiation energy: 70 W/cm$^2$, irradiation time: 7.1 seconds) through use of a UV irradiation apparatus (manufactured by Nitto Seiki Co., Ltd., product name: "UM-810").

The resultant pressure-sensitive adhesive sheet was subjected to the evaluations (1) to (6). The results are shown in Table 1.

[Examples 2 to 16 and Comparative Examples 1 to 5]

Pressure-sensitive adhesive sheets were each obtained in the same manner as in Example 1 except that the thickness of the gas barrier layer, the thickness of the gas-generating layer, the blending amount of the UV absorber, and the blending amount of the cross-linking agent of the gas barrier layer were set as shown in Table 1. The resultant pressure-sensitive adhesive sheets were subjected to the evaluations (1) to (6). The results are shown in Table 1 to Table 4. In each of Examples 10 to 13 and 17, and Comparative Examples 3 to 5, the gas-generating layer was formed without irradiation of the gas-generating layer with UV light.

[Example 17]

The composition (1) for forming a gas-generating layer was prepared in the same manner as in Example 1.
The pressure-sensitive adhesive (2) was prepared in the same manner as in Example 1.
The pressure-sensitive adhesive (2) was applied to one surface of a polyethylene terephthalate film (manufactured by Toray Industries, Inc., product name: "LUMIRROR S10", thickness: 50 μm) so that its thickness after solvent volatilization (drying) became 10 μm. Thus, a pressure-sensitive adhesive layer was formed. The composition (1) for forming a gas-generating layer was applied to the other surface of the polyethylene terephthalate film (manufactured by Toray Industries, Inc., product name: "LUMIRROR S10", thickness: 50 μm) so that its thickness after solvent volatilization (drying) became 10 μm. Thus, a precursor layer of a gas-generating layer was formed.
The pressure-sensitive adhesive sheet thus obtained was subjected to the evaluations (1) to (6). The results are shown in Table 3.

Table 1

| Configura tion | Item | | | Example 1 | Example 2 | Example 3 | Example 4 | Example 5 | Example 6 |
|---|---|---|---|---|---|---|---|---|---|
| Gas barrier layer | Composition | | Polymer | Acrylic polymer I | Acrylic polymer I | Acrylic polymer I | Acrylic polymer I | Acrylic polymer I | Acrylic polymer I |
| | | | Cross-linking agent | TETRAD-C | TETRAD-C | TETRAD-C | TETRAD-C | TETRAD-C | TETRAD-C |
| | | | Blending amount of cross-linking agent [part(s) by weight] | 1 | 1 | 1 | 1 | 1 | 1 |
| | | | Cross-linking agent | Coronate/L | Coronate/L | Coronate/L | Coronate/L | Coronate/L | Coronate/L |
| | | | Blending amount of cross-linking agent [part(s) by weight] | 3 | 3 | 3 | 3 | 3 | 3 |
| | Thickness h(barrier) [$\mu$m] | | | 10 | 10 | 10 | 10 | 10 | 10 |
| | Modulus of elasticity Er(barrier) [MPa] | | | 0.95 | 0.95 | 0.95 | 0.95 | 0.95 | 0.95 |

EP 4 083 156 A1

| Configura tion | Item | | | Example 1 | Example 2 | Example 3 | Example 4 | Example 5 | Example 6 |
|---|---|---|---|---|---|---|---|---|---|
| Gasgeneratin g layer | Composition and the like | | Polymer | Acrylic polymer II | Acrylic polymer II | Acrylic polymer II | Acrylic polymer II | Acrylic polymer II | Acrylic polymer II |
| | | | Cross-linking agent | Coronate/L | Coronate/L | Coronate/L | Coronate/L | Coronate/L | Coronate/L |
| | | | Blending amount of cross-linking agent [part(s) by weight] | 0.2 | 0.2 | 0.2 | 0.2 | 0.2 | 0.2 |
| | | | Photopolymerization initiator | Irg127 | Irg127 | Irg127 | Irg127 | Irg127 | Irg127 |
| | | | Blending amount of photopolymerization initiator [part (s) by weight] | 3 | 3 | 3 | 3 | 3 | 3 |
| | | | Molecular weight of photopolymerization initiator | 340.4 | 340.4 | 340.4 | 340.4 | 340.4 | 340.4 |
| | | | Light absorption coefficient at 365 nm [ml/(g·cm) in MeOH] | $1.070 \times 10^2$ | $1.070 \times 10^2$ | $1.070 \times 10^2$ | $1.070 \times 10^2$ | $1.070 \times 10^2$ | $1.070 \times 10^2$ |
| | | | UV absorber | Tinuvin 400 | Tinuvin 400 | Tinuvin 400 | Tinuvin 400 | Tinuvin 400 | Tinuvin 400 |
| | | | Blending amount of UV absorber [part(s) by weight] | 20 | 20 | 20 | 10 | 10 | 10 |
| | | | Molecular weight of UV absorber | 647.8 | 647.8 | 647.8 | 647.8 | 647.8 | 647.8 |
| | | | 10% weight loss temperature of UV absorber in TGA [°C] | 391.7 | 391.7 | 391.7 | 391.7 | 391.7 | 391.7 |
| | | | Maximum absorption wavelength of UV absorber | 336 nm | 336 nm | 336 nm | 336 nm | 336 nm | 336 nm |
| | Thickness h(gas) [$\mu$m] | | | 10 | 30 | 40 | 5 | 30 | 40 |
| | Modulus of elasticity Er(gas) [MPa] | | | 1.41 | 1.41 | 1.41 | 10.61 | 10.61 | 10.61 |
| | Log Er(gas) | | | 6.15 | 6.15 | 6.15 | 7.03 | 7.03 | 7.03 |
| | $8.01 \times h(gas)^{-0.116}$ | | | 6.13 | 5.40 | 5.22 | 6.65 | 5.40 | 5.22 |
| | Lower limit value of modulus of elasticity of gas-generating layer calculated from $Log(Er(gas) \times 10^6) \geq 8.01 \times h(gas)^{-0.116}$ [MPa] | | | 1.36 | 0.25 | 0.17 | 4.42 | 0.25 | 0.17 |
| | $7.66 \times h(gas)^{-0.092}$ | | | 6.20 | 5.60 | 5.46 | 6.61 | 5.60 | 5.46 |
| | Lower limit value of modulus of elasticity of gas-generating layer calculated from $Log(Er (gas) \times 10^6) \geq 7.66 \times h(gas)^{-0.092}$ [MPa] | | | 1.58 | 0.40 | 0.29 | 4.03 | 0.40 | 0.29 |

EP 4 083 156 A1

20

| Configura tion | Item | | | Example 1 | Example 2 | Example 3 | Example 4 | Example 5 | Example 6 |
|---|---|---|---|---|---|---|---|---|---|
| | $7.52 \times h(gas)^{-0.081}$ | | | 6.24 | 5.71 | 5.58 | 6.60 | 5.71 | 5.58 |
| | Lower limit value of modulus of elasticity of gas-generating layer calculated from $Log(Er(gas) \times 10^6) \geq 7.52 \times h(gas)^{-0.081}$ [MPa] | | | 1.74 | 0.51 | 0.38 | 3.99 | 0.51 | 0.38 |
| | $47.675 \times h(gas)^{-0.519}$ | | | 14.43 | 8.16 | 7.03 | 20.68 | 8.16 | 7.03 |
| | Upper limit value of modulus of elasticity of gasgenerating layer calculated from $Log (Er (gas) \times 10^6) \geq 47.675 \times h (gas)^{-0.519}$ [MPa] | | | $2.7 \times 10^8$ | 144.39 | 10.66 | $4.8 \times 10^{14}$ | 144.39 | 10.66 |
| Base material layer | Material | | | PET | PET | PET | PET | PET | PET |
| | Thickness [$\mu$m] | | | 50 | 50 | 50 | 50 | 50 | 50 |
| Pressure-sensitive adhesive layer | Composition | Polymer | | Acrylic polymer I | Acrylic polymer I | Acrylic polymer I | Acrylic polymer I | Acrylic polymer I | Acrylic polymer I |
| | | Cross-linking agent | | TETRAD-C | TETRAD-C | TETRAD-C | TETRAD-C | | TETRAD-C |
| | | Blending amount of cross-linking agent [part(s) by weight] | | 2 | 2 | 2 | 2 | 2 | 2 |
| | Thickness [$\mu$m] | | | 10 | 10 | 10 | 10 | 10 | 10 |

EP 4 083 156 A1

| Configura tion | Item | | Example 1 | Example 2 | Example 3 | Example 4 | Example 5 | Example 6 |
|---|---|---|---|---|---|---|---|---|
| Pressure-sensitive adhesive sheet | Thickness [$\mu$m] | | 80 | 100 | 110 | 75 | 100 | 110 |
| | Initial pressure-sensitive adhesive strength to SUS304BA [N/20 mm] (Gas barrier layer or gas-generating layer side) | | 0.60 | 0.82 | 1.00 | 0.53 | 0.93 | 1.15 |
| | Ordinary-state pressure-sensitive adhesive strength to PET #25 [N/20 mm] (Pressure-sensitive adhesive layer side) | | 0.71 | 0.67 | 0.78 | 0.80 | 0.72 | 0.72 |
| | Light transmittanc e | Transmittance at 360 nm [%] | 1.40 | 0.02 | 0.00 | 14.17 | 0.21 | 0.04 |
| | | Transmittance at 380 nm [%] | 58.08 | 31.24 | 22.91 | 77.14 | 49.19 | 41.08 |
| | | Transmittance at 500 nm [%] | 91.70 | 91.65 | 91.62 | 91.89 | 91.66 | 91.57 |
| | Change in surface shape | Height (Y: perpendicular displacement) | 2.9 $\mu$m | 2.1 $\mu$m | 1.8 $\mu$m | 2.6 $\mu$m | 1.7 $\mu$m | 1.2 $\mu$m |
| | | Diameter (X: horizontal displacement) | 15.1 $\mu$m | 14.6 $\mu$m | 12.9 $\mu$m | 13.3 $\mu$m | 12.8 $\mu$m | 10.8 $\mu$m |
| | | State (Foam protrusion···foam is present when observed with microscope and does not burst) | Foam protrusion | Foam protrusion | Foam protrusion | Foam protrusion | Foam protrusion | Foam protrusion |
| | Haze [%] | | 6.2 | 6.4 | 6.3 | 6.8 | 7.1 | 6.6 |
| | Peelability and position selectivity of peeling | Displacement Y (deformation in perpendicular direction) [∘/✕] | ○ | ○ | ○ | ○ | ○ | ○ |
| | | Displacement X (deformation in horizontal direction) [∘/✕] | ○ | ○ | ○ | ○ | ○ | ○ |

Table 2

| Configura tion | | Item | Example 7 | Example 8 | Example 9 | Example 10 | Example 11 | Example 12 | Example 13 |
|---|---|---|---|---|---|---|---|---|---|
| Gas barrier layer | Composition | Polymer | Acrylic polymer I | Acrylic polymer I | Acrylic polymer I | Acrylic polymer I | Acrylic polymer I | Acrylic polymer I | Acrylic polymer I |
| | | Cross-linking agent | TETRAD-C | TETRAD-C | TETRAD-C | TETRAD-C | TETRAD-C | TETRAD-C | TETRAD-C |
| | | Blending amount of cross-linking agent [part(s) by weight] | 1 | 1 | 1 | 1 | 1 | 1 | 1 |
| | | Cross-linking agent | Coronate/L | Coronate/L | Coronate/L | Coronate/L | Coronate/L | Coronate/L | Coronate/L |
| | | Blending amount of cross-linking agent [part(s) by weight] | 3 | 3 | 3 | 3 | 3 | 3 | 3 |
| | Thickness h(barrier) [$\mu$m] | | 10 | 10 | 10 | 10 | 10 | 10 | 10 |
| | Modulus of elasticity Er(barrier) [MPa] | | 0.95 | 0.95 | 0.95 | 0.95 | 0.95 | 0.95 | 0.95 |
| Gasgeneratin g layer | Composition and the like | Polymer | Acrylic polymer II | Acrylic polymer II | Acrylic polymer II | Acrylic polymer II | Acrylic polymer II | Acrylic polymer II | Acrylic polymer II |
| | | Cross-linking agent | Coronate/L | Coronate/L | Coronate/L | Coronate/L | Coronate/L | Coronate/L | Coronate/L |
| | | Blending amount of cross-linking agent [part(s) by weight] | 0.2 | 0.2 | 0.2 | 3 | 3 | 1 | 0.2 |
| | | Photopolymerization initiator | Irg127 | Irg127 | Irg127 | Irg127 | Irg127 | Irg127 | Irg127 |
| | | Blending amount of photopolymerization initiator [part(s) by weight] | 3 | 3 | 3 | 3 | 3 | 3 | 3 |
| | | Molecular weight of photopolymerization initiator | 340.4 | 340.4 | 340.4 | 340.4 | 340.4 | 340.4 | 340.4 |
| | | Light absorption coefficient at 365 nm [ml/(g·cm) in MeOH] | $1.070 \times 10^2$ | $1.070 \times 10^2$ | $1.070 \times 10^2$ | $1.070 \times 10^2$ | $1.070 \times 10^2$ | $1.070 \times 10^2$ | $1.070 \times 10^2$ |
| | | UV absorber | Tinuvin 400 | Tinuvin 400 | Tinuvin 400 | Tinuvin 400 | Tinuvin 400 | Tinuvin 400 | Tinuvin 400 |

EP 4 083 156 A1

| Configura tion | Item | | Example 7 | Example 8 | Example 9 | Example 10 | Example 11 | Example 12 | Example 13 |
|---|---|---|---|---|---|---|---|---|---|
| | | Blending amount of UV absorber [part(s) by weight] | 5 | 5 | 5 | 20 | 20 | 20 | 20 |
| | | Molecular weight of UV absorber | 647.8 | 647.8 | 647.8 | 647.8 | 647.8 | 647.8 | 647.8 |
| | | 10% weight loss temperature of UV absorber in TGA [°C] | 391.7 | 391.7 | 391.7 | 391.7 | 391.7 | 391.7 | 391.7 |
| | | Maximum absorption wavelength of UV absorber | 336 nm | 336 nm | 336 nm | 336 nm | 336 nm | 336 nm | 336 nm |
| | Thickness h(gas) [$\mu$m] | | 3 | 20 | 30 | 10 | 15 | 15 | 30 |
| | Modulus of elasticity Er(gas) [MPa] | | 29.14 | 29.14 | 29.14 | 1.44 | 1.44 | 1.01 | 0.37 |
| | Log Er(gas) | | 7.46 | 7.46 | 7.46 | 6.16 | 6.16 | 6.00 | 5.56 |
| | $8.01 \times$h(gas)$^{-0.116}$ | | 7.05 | 5.66 | 5.40 | 6.13 | 5.85 | 5.85 | 5.40 |
| | Lower limit value of modulus of elasticity of gas-generating layer calculated from Log (Er(gas) $\times 10^6) \geq 8.01 \times$h(gas)$^{-0.116}$ [MPa] | | 11.26 | 0.46 | 0.25 | 1.36 | 0.71 | 0.71 | 0.25 |
| | $7.66 \times$h(gas)$^{-0.092}$ | | 6.92 | 5.81 | 5.60 | 6.20 | 5.97 | 5.97 | 5.60 |
| | Lower limit value of modulus of elasticity of gas-generating layer calculated from Log(Er(gas) $\times 10^6) \geq 7.66 \times$h(gas)$^{-0.092}$ [MPa] | | 8.39 | 0.65 | 0.40 | 1.58 | 0.93 | 0.93 | 0.40 |
| | $7.52 \times$h(gas)$^{-0.081}$ | | 6.88 | 5.90 | 5.71 | 6.24 | 6.04 | 6.04 | 5.71 |
| | Lower limit value of modulus of elasticity of gas-generating layer calculated from Log(Er(gas) $\times 10^6) \geq 7.52 \times$h(gas)$^{-0.081}$ [MPa] | | 7.58 | 0.79 | 0.51 | 1.74 | 1.09 | 1.09 | 0.51 |
| | $47.675 \times$h(gas)$^{-0.519}$ | | 26.96 | 10.07 | 8.16 | 14.43 | 11.69 | 11.69 | 8.16 |
| | Upper limit value of modulus of elasticity of gas-generating layer calculated from Log(Er(gas) $\times 10^6) \geq 47.675 \times$h(gas)$^{-0.519}$ [MPa] | | $9 \times 10^{20}$ | 11,765.71 | 144.39 | $2.7 \times 10^8$ | $4.9 \times 10^5$ | $4.9 \times 10^5$ | 144.39 |

| Configura tion | Item | | Example 7 | Example 8 | Example 9 | Example 10 | Example 11 | Example 12 | Example 13 |
|---|---|---|---|---|---|---|---|---|---|
| Base material layer | Material | | PET | PET | PET | PET | PET | PET | PET |
| | Thickness [μm] | | 50 | 50 | 50 | 50 | 50 | 50 | 50 |
| Pressure-sensitive adhesive layer | Composition | Polymer | Acrylic polymer I | Acrylic polymer I | Acrylic polymer I | Acrylic polymer I | Acrylic polymer I | Acrylic polymer I | Acrylic polymer I |
| | | Cross-linking agent | TETRAD-C | TETRAD-C | TETRAD-C | TETRAD-C | TETRAD-C | TETRAD-C | TETRAD-C |
| | | Blending amount of cross-linking agent [part(s) by weight] | 2 | 2 | 2 | 2 | 2 | 2 | 2 |
| | Thickness [μm] | | 10 | 10 | 10 | 10 | 10 | 10 | 10 |
| | Thickness [μm] | | 73 | 90 | 100 | 80 | 85 | 85 | 100 |
| | Initial pressure-sensitive adhesive strength to SUS304BA [N/20 mm] (Gas barrier layer or gas-generating layer side) | | 0.47 | 0.62 | 0.74 | 0.50 | 0.69 | 1.21 | 0.96 |
| | Ordinary-state pressure-sensitive adhesive strength to PET #25 [N/20 mm] (Pressure-sensitive adhesive layer side) | | 0.65 | 0.70 | 0.81 | 0.71 | 0.67 | 0.78 | 0.78 |

EP 4 083 156 A1

| Configura tion | Item | | Example 7 | Example 8 | Example 9 | Example 10 | Example 11 | Example 12 | Example 13 |
|---|---|---|---|---|---|---|---|---|---|
| Pressure-sensitive adhesive sheet | Light transmittance | Transmittance at 360 nm [%] | 38.91 | 7.35 | 2.76 | 1.40 | 0.50 | 0.50 | 0.02 |
| | | Transmittance at 380 nm [%] | 84.34 | 72.38 | 66.15 | 58.08 | 49.74 | 49.74 | 31.24 |
| | | Transmittance at 500 nm [%] | 91.95 | 91.81 | 91.73 | 91.70 | 91.69 | 91.69 | 91.65 |
| | Change in surface shape | Height (Y: perpendicular displacement) | 1.6 $\mu$m | 1.0 $\mu$m | 1.1 $\mu$m | 2.3 $\mu$m | 2.2 $\mu$m | 1.5 $\mu$m | 1.1 $\mu$m |
| | | Diameter (X: horizontal displacement) | 11.4 $\mu$m | 11.1 $\mu$m | 10.2 $\mu$m | 15.1 $\mu$m | 14.6 $\mu$m | 12.9 $\mu$m | 12.9 $\mu$m |
| | | State (Foam protrusion···foam is present when observed with microscope and does not burst) | Foam protrusion | Foam protrusion | Foam protrusion | Foam protrusion | Foam protrusion | Foam protrusion | Foam protrusion |
| | Haze [%] | | 6.1 | 7 | 7.1 | 6.2 | 6.4 | 6.3 | 6.3 |
| | Peelability and position selectivity of peeling | Displacement Y (deformation in perpendicular direction) [○/×] | ○ | ○ | ○ | ○ | ○ | ○ | ○ |
| | | Displacement X (deformation in horizontal direction) [○/×] | ○ | ○ | ○ | ○ | ○ | ○ | ○ |

EP 4 083 156 A1

Table 3

| Configuration | Item | | | Example 14 | Example 15 | Example 16 | Example 17 |
|---|---|---|---|---|---|---|---|
| Gas barrier layer | Composition | | Polymer | Acrylic polymer I | Acrylic polymer I | Acrylic polymer I | |
| | | | Cross-linking agent | TETRAD-C | TETRAD-C | TETRAD-C | - |
| | | | Blending amount of cross-linking agent [part(s) by weight] | 1 | 1 | 1 | |
| | | | Cross-linking agent | Coronate/L | Coronate/L | Coronate/L Coronate/L | - - |
| | | | Blending amount of cross-linking agent [part(s) by weight] | 3 | 3 | 3 | |
| | | Thickness h(barrier) [$\mu m$] | | 50 | 10 | 60 | 0 |
| | | Modulus of elasticity Er(barrier) [MPa] | | 0.95 | 0.95 | 0.95 | 0.00 |

| Configura tion | Item | | | Example 14 | Example 15 | Example 16 | Example 17 |
|---|---|---|---|---|---|---|---|
| Gasgeneratin g layer | Composition and the like | Polymer | | Acrylic polymer II | Acrylic polymer II | Acrylic polymer II | Acrylic polymer II |
| | | Cross-linking agent | | Coronate/L | Coronate/L | Coronate/L | Coronate/L |
| | | Blending amount of cross-linking agent [part(s) by weight] | | 0.2 | 0.2 | 0.2 | 1 |
| | | Photopolymerization initiator | | Irg127 | Irg127 | Irg127 | Irg127 |
| | | Blending amount of photopolymerization initiator [part(s) by weight] | | 3 | 3 | 3 | 3 |
| | | Molecular weight of photopolymerization initiator | | 340.4 | 340.4 | 340.4 | 340.4 |
| | | Light absorption coefficient at 365 nm [ml/(g·cm) in MeOH] | | $1.070\times10^2$ | $1.070\times10^2$ | $1.070\times10^2$ | $1.070\times10^2$ |
| | | UV absorber | | Tinuvin 400 | Tinuvin 400 | Tinuvin 400 | Tinuvin 400 |
| | | Blending amount of UV absorber [part(s) bv weight] | | 20 | 5 | 20 | 20 |
| | | Molecular weight of UV absorber | | 647.8 | 647.8 | 647.8 | 647.8 |
| | | 10% weight loss temperature of UV absorber in TGA [°C] | | 391.7 | 391.7 | 391.7 | 391.7 |
| | | Maximum absorption wavelength of UV absorber | | 336 nm | 336 nm | 336 nm | 336 nm |
| | Thickness h(gas) [$\mu$m] | | | 10 | 60 | 10 | 20 - |
| | Modulus of elasticity Er(gas) [MPa] | | | 1.41 | 29.14 | 1.41 | 1.01 |
| | Log Er(gas) | | | 6.15 | 7.46 | 6.15 | 6.00 |
| | $8.01\times h(gas)^{-0.116}$ | | | 6.13 | 4.98 | 6.13 | 5.66 |
| | Lower limit value of modulus of elasticity of gas-generating layer calculated from $Log(Er(gas)\times10^6)\geq8.01\times h(gas)^{-0.116}$ [MPa] | | | 1.36 | 0.10 | 1.36 | 0.46 |
| | $7.66\times h(gas)^{-0.092}$ | | | 6.20 | 5.26 | 6.20 | 5.81 |
| | Lower limit value of modulus of elasticity of gas-generating layer calculated from $Log(Er(gas)\times10^6)\geq7.66\times h(gas)^{-0.092}$ [MPa] | | | 1.58 | 0.18 | 1.58 | 0.65 |

EP 4 083 156 A1

| Configura tion | Item | | | Example 14 | Example 15 | Example 16 | Example 17 |
|---|---|---|---|---|---|---|---|
| | $7.52 \times h(gas)^{-0.081}$ | | | 6.24 | 5.40 | 6.24 | 5.90 |
| | Lower limit value of modulus of elasticity of gas-generating layer calculated from $Log(Er(gas) \times 10^6) \geq 7.52 \times h(gas)^{-0.081}$ [MPa] | | | 1.74 | 0.25 | 1.74 | 0.79 |
| | $47.675 \times h(gas)^{-0.519}$ | | | 14.43 | 5.69 | 14.43 | 10.07 |
| | Upper limit value of modulus of elasticity of gasgenerating layer calculated from $Log(Er(gas) \times 10^6) \geq 47.675 \times h(gas)^{-0.519}$ [MPa] | | | $2.7 \times 10^8$ | 0.49 | $3 \times 10^8$ | $1.2 \times 10^4$ |
| Base material layer | Material | | | PET | PET | PET | PET |
| | Thickness [$\mu$m] | | | 50 | 50 | 50 | 50 |
| Pressuresensitive adhesive layer | Composition | Polymer | | Acrylic polymer I | Acrylic polymer I | Acrylic polymer I | Acrylic polymer I |
| | | Cross-linking agent | | TETRAD-C | TETRAD-C | TETRAD-C | TETRAD-C |
| | | Blending amount of cross-linking agent [part(s) by weight] | | 2 | 2 | 2 | 2 |
| | Thickness [$\mu$m] | | | 10 | 10 | 10 | 10 |

EP 4 083 156 A1

(continued)

| Configuration | Item | | Example 14 | Example 15 | Example 16 | Example 17 |
|---|---|---|---|---|---|---|
| Pressure-sensitive adhesive sheet | Thickness [μm] | | 120 | 130 | 130 | 80 |
| | Initial pressure-sensitive adhesive strength to SUS304BA [N/20 mm] (Gas barrier layer or gas-generating layer side) | | 2.51 | 0.71 | 3.81 | 4.53 |
| | Ordinary-state pressure-sensitive adhesive strength to PET #25 [N/20 mm] (Pressure-sensitive adhesive layer side) | | 0.71 | 0.81 | 0.71 | 0.78 |
| | Light transmittance | Transmittance at 360 nm [%] | 1.40 | 0.15 | 1.40 | 0.18 |
| | | Transmittance at 380 nm [%] | 58.08 | 50.50 | 58.08 | 42.59 |
| | | Transmittance at 500 nm [%] | 91.70 | 91.48 | 91.70 | 91.67 |
| | Change in surface shape | Height (Y: perpendicular displacement) | 1.0 μm | 0.6 μm | 0.7 μm | 1.4 μm |
| | | Diameter (X: horizontal displacement) | 15.1 μm | 30.1 μmφ | 34.1 μm | 24.7 μm |
| | | State (Foam protrusion···foam is present when observed with microscope and does not burst) | Foam protrusion | Foam (slightly flat) | Foam (slightly flat) | Foam protrusion |
| | Haze [%] | | 6.2 | 7.1 | 6.2 | 4.1 |
| | Peelability and position selectivity of peeling | Displacement Y (deformation in perpendicular direction) [○/×] | ○ | △ | △ | ○ |
| | | Displacement X (deformation in horizontal direction) [○/×] | ○ | ○ | ○ | ○ |

Table 4

| Configura tion | Item | | | Comparativ e Example 1 | Comparativ e Example 2 | Comparativ e Example 3 | Comparativ e Example 4 | Comparativ e Example 5 |
|---|---|---|---|---|---|---|---|---|
| Gas barrier layer | Composition | Polymer | | Acrylic polymer I | Acrylic polymer I | Acrylic polymer I | Acrylic polymer I | Acrylic polymer I |
| | | Cross-linking agent | | TETRAD-C | TETRAD-C | TETRAD-C | TETRAD-C | TETRAD-C |
| | | Blending amount of cross-linking agent [part(s) by weight] | | 1 | 1 | 1 | 1 | 1 |
| | | Cross-linking agent | | Coronate/L | Coronate/L | Coronate/L | Coronate/L | Coronate/L |
| | | Blending amount of cross-linking agent [part(s) by weight] | | 3 | 3 | 3 | 3 | 3 |
| | Thickness h(barrier) [$\mu$m] | | | 10 | 10 | 10 | 10 | 10 |
| | Modulus of elasticity Er(barrier) [MPa] | | | 0.95 | 0.95 | 0.95 | 0.95 | 0.95 |

| Configura tion | Item | | | Comparativ e Example 1 | Comparativ e Example 2 | Comparativ e Example 3 | Comparativ e Example 4 | Comparativ e Example 5 |
|---|---|---|---|---|---|---|---|---|
| Gasgeneratin g layer | Composition and the like | Polymer | | Acrylic polymer II | Acrylic polymer II | Acrylic polymer II | Acrylic polymer II | Acrylic polymer II |
| | | Cross-linking agent | | Coronate/L | Coronate/L | Coronate/L | Coronate/L | Coronate/L |
| | | Blending amount of cross-linking agent [part(s) by weight] | | 0.2 | 0.2 | 3 | 1 | 0.2 |
| | | Photopolymerization initiator | | Irg127 | Irg127 | Irg127 | Irg127 | Irg127 |
| | | Blending amount of photopolymerization initiator [part(s) by weight] | | 3 | 3 | 3 | 3 | 3 |
| | | Molecular weight of photopolymerization initiator | | 340.4 | 340.4 | 340.4 | 340.4 | 340.4 |
| | | Light absorption coefficient at 365 nm [ml/(g·cm) in MeOH] | | $1.070\times10^2$ | $1.070\times10^2$ | $1.070\times10^2$ | $1.070\times10^2$ | $1.070\times10^2$ |
| | | UV absorber | | Tinuvin 400 | Tinuvin 400 | Tinuvin 400 | Tinuvin 400 | Tinuvin 400 |
| | | Blending amount of UV absorber [part(s) by weight] | | 20 | 10 | 20 | 20 | 20 |
| | | Molecular weight of UV absorber | | 647.8 | 647.8 | 647.8 | 647.8 | 647.8 |
| | | 10% weight loss temperature of UV absorber in TGA [°C] | | 391.7 | 391.7 | 391.7 | 391.7 | 391.7 |
| | | Maximum absorption wavelength of UV absorber | | 336 nm | 336 nm | 336 nm | 336 nm | 336 nm |
| | Thickness h(gas) [$\mu$m] | | | 5 | 3 | 5 | 10 | 20 |
| | Modulus of elasticity Er(gas) [MPa] | | | 1.41 | 10.61 | 1.44 | 1.01 | 0.37 |
| | Loq Er(gas) | | | 6.15 | 7.03 | 6.16 | 6.00 | 5.56 |
| | $8.01\times h(gas)^{-0.116}$ | | | 6.65 | 7.05 | 6.65 | 6.13 | 5.66 |
| | Lower limit value of modulus of elasticity of gas-generating layer calculated from $Log(Er(gas)\times10^6)\geq8.01\times h(gas)^{-0.116}$ [MPa] | | | 4.42 | 11.26 | 4.42 | 1.36 | 0.46 |
| | $7.66\times h(gas)^{-0.092}$ | | | 6.61 | 6.92 | 6.61 | 6.20 | 5.81 |
| | Lower limit value of modulus of elasticity of gas-generating layer calculated from $Log(Er(gas)\times10^6)\geq7.66\times h(gas)^{-0.092}$ [MPa] | | | 4.03 | 8.39 | 4.03 | 1.58 | 0.65 |

EP 4 083 156 A1

32

(continued)

| Configura tion | Item | | | Comparativ e Example 1 | Comparativ e Example 2 | Comparativ e Example 3 | Comparativ e Example 4 | Comparativ e Example 5 |
|---|---|---|---|---|---|---|---|---|
| | $7.52 \times h(gas)^{-0.081}$ | | | 6.60 | 6.88 | 6.60 | 6.24 | 5.90 |
| | Lower limit value of modulus of elasticity of gas-generating layer calculated from $Log(Er(gas) \times 10^6) \geq 7.52 \times h(gas)^{-0.081}$ [MPa] | | | 3.99 | 7.58 | 3.99 | 1.74 | 0.79 |
| | $47.675 \times h(gas)^{-0.519}$ | | | 20.68 | 26.96 | 20.68 | 14.43 | 10.07 |
| | Upper limit value of modulus of elasticity of gas-generating layer calculated from $Log(Er(gas) \times 10^6) \geq 47.675 \times h(gas)^{-0.519}$ [MPa] | | | $4.8 \times 10^{14}$ | $9 \times 10^{20}$ | $4.8 \times 10^{14}$ | $2.7 \times 10^8$ | $1.2 \times 10^4$ |
| Base | Material | | | PET | PET | PET | PET | PET |
| material layer | Thickness [$\mu$m] | | | 50 | 50 | 50 | 50 | 50 |
| Pressure-sensitive adhesive layer | Composition | Polymer | | Acrylic polymer I | Acrylic polymer I | Acrylic polymer I | Acrylic polymer I | Acrylic polymer I |
| | | Cross-linking agent | | TETRAD-C | TETRAD-C | TETRAD-C | TETRAD-C | TETRAD-C |
| | | Blending amount of cross-linking agent [part(s) by weight] | | 2 | 2 | 2 | 2 | 2 |
| | Thickness [$\mu$m] | | | 10 | 10 | 10 | 10 | 10 |

(continued)

| Configura tion | Item | | | Comparativ e Example 1 | Comparativ e Example 2 | Comparativ e Example 3 | Comparativ e Example 4 | Comparativ e Example 5 |
|---|---|---|---|---|---|---|---|---|
| Pressuresensitive adhesive sheet | Thickness [μm] | | | 75 | 73 | 75 | 80 | 90 |
| | Initial pressure-sensitive adhesive strength to SUS304BA [N/20 mm] (Gas barrier layer or gas-generating layer side) | | | 0.48 | 0.53 | 0.50 | 0.81 | 1.12 |
| | Ordinary-state pressure-sensitive adhesive strength to PET #25 [N/20 mm] (Pressure-sensitive adhesive layer side) | | | 0.70 | 0.65 | 0.71 | 0.66 | 0.78 |
| | Light transmittance | Transmittance at 360 nm [%] | | 3.89 | 5.86 | 3.89 | 1.40 | 0.18 |
| | | Transmittance at 380 nm [%] | | 67.81 | 72.15 | 67.81 | 58.08 | 42.59 |
| | | Transmittance at 500 nm [%] | | 91.72 | 91.72 | 91.72 | 91.70 | 91.67 |
| | Change in surface shape | Height (Y: perpendicular displacement) | | 12.1 μm | 11.0 μm | 13.4 μm | 15.6 μm | 18.9 μm |
| | | Diameter (X: horizontal displacement) | | 53.6 μm | 56.0 μm | 51.1 μm | 53.2 μm | 50.9 μm |
| | | State (Foam protrusion···foam is present when observed with microscope and does not burst) (Burst depression···depressed by gasification) | | Burst depression | Burst depression | Burst depression | Burst depression | Burst depression |
| | Haze [%] | | | 5.5 | 6 | 7.4 | 6.5 | 6.3 |
| | Peelability and position | Displacement Y (deformation in perpendicular direction) [○/✕] | | ○ | ○ | ○ | ○ | ○ |
| | selectivity of peeling | Displacement X (deformation in horizontal direction) [○/✕] | | ✕ | ✕ | ✕ | ✕ | ✕ |

EP 4 083 156 A1

Reference Signs List

| | |
|---|---|
| **10** | gas-generating layer |
| **20** | gas barrier layer |
| **100, 200** | pressure-sensitive adhesive sheet |

**Claims**

1. A pressure-sensitive adhesive sheet, comprising a gas-generating layer configured to generate a gas by being irradiated with laser light, wherein a modulus of elasticity Er(gas) [unit: MPa] of the gas-generating layer measured by a nanoindentation method and a thickness h(gas) [unit: $\mu$m] thereof satisfy the following expression (1).

$$\mathrm{Log}(\mathrm{Er}(\mathrm{gas}) \times 10^6) \geq 8.01 \times \mathrm{h}(\mathrm{gas})^{-0.116} \cdots (1)$$

2. The pressure-sensitive adhesive sheet according to claim 1, wherein the pressure-sensitive adhesive sheet has a transmittance of from 0% to 40% for light having a wavelength of 360 nm.

3. The pressure-sensitive adhesive sheet according to claim 1 or 2, wherein the pressure-sensitive adhesive sheet has a transmittance of from 10% to 100% for light having a wavelength of 380 nm.

4. The pressure-sensitive adhesive sheet according to any one of claims 1 to 3,

    wherein the gas-generating layer contains a UV absorber, and
    wherein the UV absorber has a maximum absorption wavelength of 360 nm or less.

5. The pressure-sensitive adhesive sheet according to any one of claims 1 to 4, wherein the gas-generating layer is a cured product of an active energy ray-curable composition.

6. The pressure-sensitive adhesive sheet according to any one of claims 1 to 5, wherein the gas-generating layer contains an acrylic polymer.

7. The pressure-sensitive adhesive sheet according to any one of claims 1 to 6, further comprising a gas barrier layer on at least one side of the gas-generating layer, wherein the gas barrier layer has a modulus of elasticity of from 0.1 MPa to 100 MPa, which is measured by the nanoindentation method.

8. The pressure-sensitive adhesive sheet according to claim 7, wherein the gas barrier layer has a thickness of from 0.1 $\mu$m to 50 $\mu$m.

9. The pressure-sensitive adhesive sheet according to any one of claims 1 to 8, wherein the gas barrier layer shows a pressure-sensitive adhesive property.

10. The pressure-sensitive adhesive sheet according to any one of claims 1 to 9, wherein the pressure-sensitive adhesive sheet has a transmittance of from 70% to 100% for light having a wavelength of 500 nm.

11. The pressure-sensitive adhesive sheet according to any one of claims 1 to 10, wherein the pressure-sensitive adhesive sheet has a haze value of 50% or less.

12. The pressure-sensitive adhesive sheet according to any one of claims 1 to 11, wherein a surface of the pressure-sensitive adhesive sheet is deformed by being irradiated with laser light.

13. The pressure-sensitive adhesive sheet according to claim 12, wherein the surface of the pressure-sensitive adhesive sheet is deformed into a protrusion shape by being irradiated with the laser light.

14. The pressure-sensitive adhesive sheet according to claim 12 or 13, wherein a horizontal displacement of the surface of the pressure-sensitive adhesive sheet by the irradiation of the pressure-sensitive adhesive sheet with the laser light is 50 $\mu$m or less.

15. A method of treating an electronic part, comprising:

bonding an electronic part onto the pressure-sensitive adhesive sheet of any one of claims 1 to 14; and
peeling the electronic part from the pressure-sensitive adhesive sheet by irradiating the pressure-sensitive adhesive sheet with laser light.

16. The method of treating an electronic part according to claim 15, wherein the peeling the electronic part is performed in a position-selective manner.

17. The method of treating an electronic part according to claim 15 or 16, further comprising subjecting the electronic part to a predetermined treatment after the bonding the electronic part onto the pressure-sensitive adhesive sheet and before the peeling the electronic part from the pressure-sensitive adhesive sheet.

18. The method of treating an electronic part according to claim 17, wherein the treatment is grinding processing, dicing processing, die bonding, wire bonding, etching, vapor deposition, molding, circuit formation, inspection, a product check, cleaning, transfer, arrangement, repair, or protection of a device surface.

19. The method of treating an electronic part according to any one of claims 15 to 18, further comprising placing the electronic part on another sheet after the peeling the electronic part from the pressure-sensitive adhesive sheet.

100

Fig.1(a)

10

30

200

Fig.1(b)

20

10

30

## INTERNATIONAL SEARCH REPORT

International application No.

PCT/JP2020/044515

A. CLASSIFICATION OF SUBJECT MATTER
Int. Cl. C09J11/06(2006.01)i, C09J201/00(2006.01)i, H01L21/301(2006.01)i,
C09J7/20(2018.01)i, C09J7/24(2018.01)i, C09J7/38(2018.01)i
FI: C09J7/20, C09J7/38, C09J201/00, C09J11/06, C09J7/24, H01L21/78 M

According to International Patent Classification (IPC) or to both national classification and IPC

B. FIELDS SEARCHED

Minimum documentation searched (classification system followed by classification symbols)
Int. Cl. C09J11/06, C09J201/00, H01L21/301, C09J7/20, C09J7/24, C09J7/38

Documentation searched other than minimum documentation to the extent that such documents are included in the fields searched
Published examined utility model applications of Japan     1922-1996
Published unexamined utility model applications of Japan   1971-2021
Registered utility model specifications of Japan           1996-2021
Published registered utility model applications of Japan   1994-2021

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2003-342540 A (ASAHI KASEI CORP.) 03 December 2003, claims, examples | 1-19 |
| A | JP 2010-202833 A (SEKISUI CHEMICAL CO., LTD.) 16 September 2010, claims, examples | 1-19 |
| A | JP 2019-70104 A (SEKISUI CHEMICAL CO., LTD.) 09 May 2019, claims, examples | 1-19 |
| A | JP 2010-129699 A (NITTO DENKO CORP.) 10 June 2010, claims, examples | 1-19 |
| A | JP 2018-141086 A (NITTO DENKO CORP.) 13 September 2018, claims, examples | 1-19 |

☒ Further documents are listed in the continuation of Box C.      ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 05.01.2021 | 19.01.2021 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

| International application No. |
| --- |
| PCT/JP2020/044515 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2018-182276 A (NITTO DENKO CORP.) 15 November 2018, claims, examples | 1-19 |

Form PCT/ISA/210 (continuation of second sheet) (January 2015)

**INTERNATIONAL SEARCH REPORT**

Information on patent family members

| International application No. |
|---|
| PCT/JP2020/044515 |

| Patent Documents referred to in the Report | Publication Date | Patent Family | Publication Date |
|---|---|---|---|
| JP 2003-342540 A | 03.12.2003 | (Family: none) | |
| JP 2010-202833 A | 16.09.2010 | (Family: none) | |
| JP 2019-70104 A | 09.05.2019 | (Family: none) | |
| JP 2010-129699 A | 10.06.2010 | US 2010/0129988 A1 claims, examples | |
| JP 2018-141086 A | 13.09.2018 | CN 108504298 A KR 10-2018-0099506 A | |
| JP 2018-182276 A | 15.11.2018 | JP 2018-182275 A JP 2018-182294 A CN 108727999 A KR 10-2018-0116756 A CN 108735651 A CN 108728000 A KR 10-2018-0116750 A KR 10-2018-0116751 A | |

Form PCT/ISA/210 (patent family annex) (January 2015)

EP 4 083 156 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001131507 A